# EUROPEAN PATENT APPLICATION

(11) **EP 4 513 553 A2**
(43) Date of publication of application: **26.02.2025**
(21) Application number: 24192710.2
(22) Date of filing: 02.08.2024
(51) Int. Cl.: H01L 23/498, H01L 23/538, H01L 23/00, H01L 25/16, H01L 23/50

(54) **CAPACITOR CARRIER RING AND STIFFENER FOR INTEGRATED CIRCUIT PACKAGE ASSEMBLY**

(30) Priority: 03.08.2023 US 202318229959
(71) Applicant: Google LLC, Mountain View, CA 94043 (US)
(72) Inventor: Kirkman, Scott Lee, Mountain View, 94043 (US); Kim, Nam Hoon, Mountain View, 94043 (US); Mohammed, Ilyas, Mountain, 94043 (US)
(74) Representative: Betten & Resch

(57) **Abstract**

A microelectronic package assembly is disclosed that implements a capacitor carrier capable of providing package warpage control and that eliminates the need to only bond chip capacitors directly to a surface of the package substrate. The capacitor carrier may be composed of a material that has a high coefficient of thermal expansion and a high Young's modulus. A capacitor carrier with these characteristics can eliminate the need for a traditional stiffener in the chip package.

## Description

### BACKGROUND OF THE INVENTION

As computer power and performance requirements for high performance computing ("HPC") chips and integrated circuit ("IC") chips increase, unique challenges are placed on the design, manufacture, and performance of semiconductor chip packages. One challenge is power delivery. HPC chips require high amounts of power over a wide range of frequencies. Discrete chip capacitors are often incorporated into the chip package assembly to help supply sufficient power at the target frequencies. But, as the need for more power increases due to corresponding increases in chip performance, so do the number of chip capacitors required in the chip package.

Finding space for the growing number of chip capacitors is difficult. Capacitors are often located at the bottom of the package substrate and require removal of solder ball connections formed in a ball grid array ("BGA"). BGA removal impacts optimal chip operating conditions, as it not only limits the number of connections available to the printed circuit board ("PCB"), but the remaining solder ball connections formed in BGAs are forced to carry a greater percentage of the electrical current needed to power the chip. Further, to limit the risk of electromigration ("EM") failures within the solder balls, the electrical current per ball must be designed to remain under certain limits. Designs today push these limits.

Warpage is another critical challenge facing the manufacture of IC packages (e.g., mechanical bending and/or twisting). With larger IC chips and/or an increasing number of chips being provided onto a single package, larger chip packages must be designed and manufactured to accommodate these chips. These large packages result in higher levels of warpage, requiring the use of external devices to control the warpage and enable smooth processing through assembly and testing. It is challenging to relocate or add capacitors to the top side of the package due to the majority of the surface area outside of the die/interposer area being occupied by the warpage control device, such as a metal lid or stiffener. As a result, it is becoming increasingly difficult to efficiently accommodate the required and increased number of chip capacitors on the chip package.

Lastly, accommodating the height of capacitors in chip packages can pose another significant limitation for chip packaging technology. Taller capacitors have greater capacitance values. However, capacitors that exceed approximately 300 microns in height necessitate routing a cavity within the PCB to provide space for the capacitors. This adds significant cost and complexity to the PCB design and fabrication process.

### BRIEF SUMMARY

Microelectronic element package assemblies are disclosed that implement a capacitor carrier capable of providing package warpage control and that eliminates the need to only bond chip capacitors directly to a surface of the package substrate. The capacitor carrier may be composed of a material that has a high coefficient of thermal expansion and a high Young's modulus. A capacitor carrier with these characteristics can eliminate the need for a traditional stiffener in the chip package.

According to one aspect of the disclosure, a microelectronic element package assembly includes a package substrate, at least two microelectronic elements electrically connected to the substrate contacts, a microelectronic element capacitor carrier overlying and joined to the package substrate, and a plurality of capacitors joined to the capacitor carrier. The package substrate includes a substrate body, substrate contacts disposed at a top surface of the substrate body, package terminals disposed at a bottom surface of the substrate body, and routing lines disposed between the top and bottom surfaces. The microelectronic element capacitor carrier overlies and is joined to the package substrate, The capacitor carrier includes a plurality of ground contacts electrically connected to a ground source; a plurality of power contacts electrically connected to a power source; and, capacitor routing lines. At least some of the capacitor routing lines are connected to the plurality of ground contacts and other capacitor routing lines are electrically connected to the plurality of power contacts. The capacitor carrier is positioned laterally adjacent to the at least two microelectronic elements and extends at least partially around the at least two microelectronic elements so that an inner edge of the capacitor carrier is adjacent to the outer edges of the at least two microelectronic elements. A plurality of capacitors may be joined to the capacitor carrier. Each of the plurality of capacitors has a first end joined to one of the plurality of ground contacts and a second end joined to one of the plurality of power contacts. At least some of the plurality of capacitors providing power to at least one of the at least two microelectronic elements.

According to another aspect of the disclosure, a microelectronic element package assembly includes a package substrate; an interposer overlying and joined to the package substrate; at least two microelectronic elements electrically connected to the package substrate through the interposer; a capacitor carrier ring ("CCR") overlying the package substrate and extending circumferentially around the at least two microelectronic elements; and, a plurality of arrays of capacitors. The CCR may include a material having a coefficient of thermal expansion ranging from 5-15 ppm/ °C and a Young's modulus ranging from 25-350 GPa. The CCR further includes a plurality of ground contacts electrically connected to a ground source and a plurality of power contacts electrically connected to a power source. Each of the plurality of capacitors in the plurality of arrays of capacitors may have a first end joined to one of the plurality of ground contacts and a second end joined to one of the plurality of power contacts. At least some of the plurality of capacitors in one or more of the plurality of arrays of capacitors are electrically connected with one of the at least two microelectronic elements and others of the plurality of capacitors are electrically interconnected with a second of the at least two microelectronic elements through an electrical connection between the CCR and the package substrate.

According to another aspect of the disclosure, a chip package assembly includes a package substrate having at least one power contact electrically connected to a power source; at least two chips electrically connected to the package substrate; a stiffening element joined to the package substrate and extending at least partially around the at least two chips; and, a plurality of chip capacitors disposed within the at least one pocket. The stiffening element may be electrically connected to a ground source so that the stiffening element is a ground and positioned directly adjacent to the at least two chips. The stiffening element may further include at least one pocket. The pocket may include an interior contact surface and interior walls extending around and away from the interior contact surface and terminating in an opening. One end of each of the plurality of chip capacitors may be joined to the interior contact surface and another end of each of the plurality of chip capacitors may be joined to the power contact.

According to another aspect of the disclosure, a method of manufacturing a microelectronic element package assembly includes providing a package substrate that includes ground and power lines, contact pads disposed at a top surface, and package terminals disposed at a bottom surface; electrically connecting at least two microelectronic elements with the contact pads of the package substrate; providing a multi-layer ceramic capacitor carrier that includes ground contacts and power contacts each disposed at top and bottom surfaces of the capacitor carrier; joining a plurality of chip capacitors to the capacitor carrier, wherein one end of each of the chip capacitors is bonded to one of the ground contacts and the other end of each of the chip capacitors is bonded to one of the power contacts; positioning the capacitor carrier and the attached plurality of chip capacitors laterally adjacent the at least two microelectronic elements so that that the capacitor carrier and the attached chip capacitors extend at least partially around the at least two microelectronic elements; and joining the multi-layer ceramic capacitor carrier to the package substrate, wherein at least some of the ground contacts are electrically connected to a ground source and other of the contact pads are power contacts electrically connected to a power source, and at least some of the plurality of capacitors supply power to least one of the at least two microelectronic elements.

According to another aspect of the disclosure, a microelectronic element package assembly includes a package substrate; a plurality of ground contacts electrically connected to a ground source; a microelectronic element capacitor carrier overlying and bonded to the package substrate, and a plurality of capacitors joined to the capacitor carrier, wherein a body of the capacitor carrier is the ground source. The package substrate includes a substrate body, substrate contacts disposed at a top surface of the substrate body, package terminals disposed at a bottom surface of the substrate body, and routing lines disposed between the top and bottom surfaces. The at least two microelectronic elements may be electrically connected to the substrate contacts. The microelectronic element capacitor may include ground contacts electrically connected to a ground source; power contacts electrically connected to a power source; a plurality of vias extending between top and bottom surfaces of the capacitor carrier; a plurality of vias extending between top and bottom surfaces of the capacitor carrier and electrically connecting the at least some of the power contacts disposed at the top and bottom surfaces of the capacitor carrier. At least some of the power contacts may be disposed at a top surface of the capacitor carrier and other power contacts may be disposed at a bottom surface of the capacitor carrier. The capacitor carrier may be positioned laterally adjacent the at least two microelectronic elements and extend at least partially around the at least two microelectronic elements so that an inner edge of the capacitor carrier is adjacent outer edges of the at least two microelectronic elements. The package assembly further includes a plurality of capacitors joined to the capacitor carrier. Each of the plurality of capacitors may have a first end joined to one of the ground contacts and a second end joined to one of the power contacts. At least some of the plurality of capacitors may provide power to at least one of the at least two microelectronic elements.

### BRIEF DESCRIPTION OF THE DRAWINGS

FIG. 1 is a schematic cross-sectional view of a microelectronic element package assembly taken across line 1-1 of FIG. 3 according to aspects of the disclosure.
FIG. 2 is a schematic top plan view of a capacitor carrier ring according to aspects of the disclosure.
FIG. 3 is a schematic top plan view of the microelectronic element package assembly according to aspects of the disclosure.
FIG. 4 is an enlarged view of a portion of FIG. 1.
FIG. 4A is an enlarged view of a portion of FIG. 4.
FIG. 5 is a schematic bottom plan view of the capacitor carrier ring shown in FIG. 2.
FIG. 6 is another example schematic bottom plan view of the capacitor carrier ring shown in FIG. 2.
FIG. 7 is a schematic top plan view of another capacitor carrier ring according to aspects of the disclosure.
FIG. 8 is a schematic top plan view of a microelectronic element package assembly implementing the capacitor carrier ring of FIG. 7, according to aspects of the disclosure.
FIG. 9 is a schematic top plan view of another capacitor carrier ring according to aspects of the disclosure.
FIG. 10 is a schematic top plan view of a microelectronic element package assembly implementing the capacitor carrier ring of FIG. 9, according to aspects of the disclosure.
FIG. 11 is a schematic top plan view of another capacitor carrier ring according to aspects of the disclosure.
FIG. 12 is a schematic top plan view of a microelectronic element package assembly implementing the capacitor carrier ring of FIG. 11, according to aspects of the disclosure.
FIG. 13 is a schematic view of a multi-layer metallized carrier sheet according to aspects of the disclosure.
FIG. 13A is a schematic cross-sectional view of FIG. 13.
FIG. 14 is a schematic cross-sectional view of a microelectronic element package according to aspects of the disclosure.
FIG. 15 is an enlarged view of a portion of FIG. 1.
FIG. 15A is an enlarged view of a portion of FIG. 4.
FIG. 15B is a schematic cross-sectional view of a microelectronic element package assembly taken across line 15B-15B of FIG. 15C according to aspects of the disclosure.
FIG. 15C is a schematic top plan view of the microelectronic element package assembly according to aspects of the disclosure.
FIG. 15D is a schematic cross-sectional view of a microelectronic package according to aspects of the disclosure.
FIG. 15E is an enlarged portion of FIG. 15D.
FIG. 15F is an enlarged portion of FIG. 15E.
FIG. 16 is a schematic cross-sectional view of a microelectronic element package assembly taken across line 16-16 of FIG. 19 according to aspects of the disclosure.
FIG. 17 is a schematic perspective view of a stiffener according to aspects of the disclosure.
FIG. 18 is an enlarged view of a portion of FIG. 16.
FIG. 19 is a schematic top plan view of the microelectronic element package of FIG. 17 according to aspects of the disclosure.
FIG. 20 is a schematic perspective view of a stiffening element according to aspects of the disclosure.
FIG. 21 is a flow diagram illustrating a method of manufacturing the microelectronic element package assembly of FIG. 1.
FIG. 22 is a flow diagram illustrating another method of manufacturing the microelectronic element package assembly of FIG. 1.

### DETAILED DESCRIPTION

Improvements to chip package assemblies continue to be made to address chip package power requirements and to remain within the electrical current limits of the solder balls within the package assembly. One aspect of the disclosure is to replace traditional warpage control devices with a capacitor carrier. In one example, a capacitor carrier can be incorporated into a chip package to provide warpage control, a large surface area to support and/or provide connections for numerous discrete decoupling chip capacitors, and to electrically connect capacitors in the package to the power delivery systems designed within the chip package. In one example, the capacitor carrier may be a capacitor carrier ring ("CCR") that overlies and extends adjacent an outer edge of the package substrate, as well as includes interconnections to power and ground supplies. CCR may provide warpage control to the package assembly and electrical interconnections that enable capacitors to supply power to other components in the chip package, such as microelectronic elements or devices, including semiconductor chips.

The CCR may be manufactured from a material possessing properties that can increase the rigidity and provide warpage control of the package assembly. For example, the CCR may be at least partially composed of a ceramic material that can help to provide sufficient rigidity in the overall chip package at high temperatures and also possesses a coefficient of thermal expansion ("CTE") that closely matches the CTE of the package substrate or a PCB. In one example, a multi-layered low temperature co-fired ceramic ("LTCC") can be utilized. When the CCR is designed to provide warpage control, CCR can replace a traditional package stiffener that takes up significant space on the top surface of the substrate package. In other examples, instead of a CCR composed of ceramic material, other materials or combinations of materials capable of providing the necessary stiffness with electric wiring can be utilized.

The CCR provides for the strategic placement of capacitors within the package assembly by providing additional surface area and routing lines to support chip capacitors in the package assembly, without taking up additional space on the package substrate. Electrical routing lines may be provided throughout the CCR, including, without limitation, ground and power lines respectively connected to a source of ground and a source of power. In this arrangement, the routing lines allow for chip capacitors to be electrically connected to a power source, a ground source, and/or other components within the package assembly.

Chip capacitors are no longer limited to being directly attached or bonded to the package substrate and may now be electrically connected to other components in the package assembly through the CCR. The CCR provides for relocation of numerous capacitors, which were previously limited to being directly bonded to the top and bottom surfaces of the package substrate, to the CCR surface. For example, all chip capacitors in the assembly may now be relocated to the CCR surface. Similarly, select capacitors may be relocated to the CCR surface and others can be relegated to being attached to the package substrate. For example, capacitors needed to provide capacitance for secondary supplies can be relocated to the top surface of the CCR in order to free up space for capacitors to be positioned at the bottom side of the package substrate that may be needed for more critical supplies and that provide a more direct connection to the microelectronic elements in the package assembly. The CCR also does not take additional space on the top surface of the package substrate since it replaces the need for a separate stiffener. The CCR can therefore reduce the number of solder balls that need to be removed from the BGA to accommodate bottom side capacitors and, in some applications, may altogether obviate the need to remove any solder balls from the BGA.

Thus, a CCR composed of a rigid material can provide the dual function of providing necessary stiffness in the package to help minimize warping and provide for relocation of chip capacitors by providing electrical connections between the capacitors and other components in the package.

In still other examples, the CCR may be comprised of a different material to achieve the desired stiffness in the package. For example, CCR may be comprised of a metal that can function as ground. Vias for power can extend through the body of the CCR to provide a power connection. In other examples, CCR may be comprised of a PCB, which requires a secondary stiffener to achieve the desired stiffness in the overall package.

In other examples, instead of implementing a CCR in the chip package assembly, a stiffening element may include recesses for receiving chip capacitors therein. The stiffening element may be bonded to the package substrate, connected to ground, and function as a ground terminal. Chip capacitors may be vertically oriented so that one end of each chip capacitor is bonded to an intermediate surface within the recess of the stiffening element and the other end of the chip capacitor is bonded to the package substrate and connected to a power line. Chip capacitors may provide power to microelectronic elements in the package assembly through the ground and power lines in the substrate which are also connected to the microelectronic elements in the package assembly.

It is to be appreciated that chip package assemblies manufactured according to aspects of the disclosure may be used in connection with various applications, including without limitation, central processing units (CPUs), graphics processing units (GPUs), and application-specific integrated units (ASICs), including tensor processing units (TPUs).

### EXAMPLE PACKAGE ASSEMBLIES

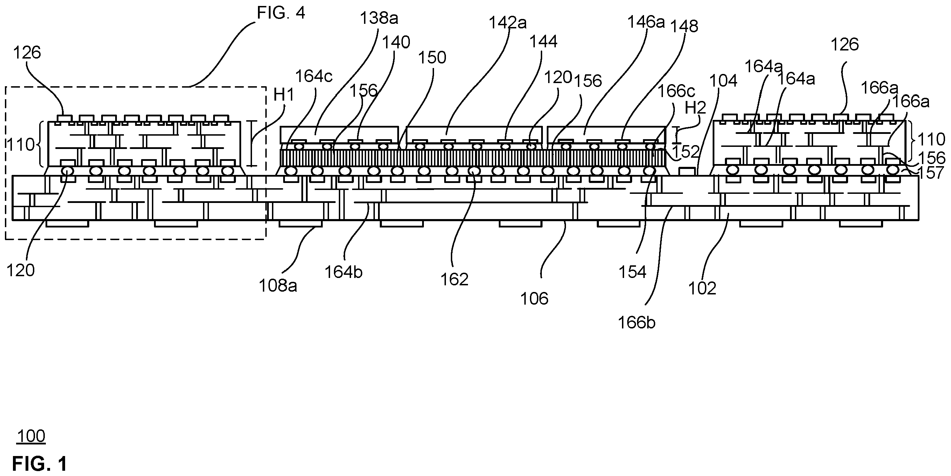

FIG. 1 illustrates a schematic cross-sectional view of a microelectronic element package assembly 100 according to aspects of the disclosure. In this example, assembly 100 includes a package substrate 102, a capacitor carrier, such as an example capacitor carrier ring ("CCR") 110 that supports capacitors 126, and an interposer 150 that electrically connects first, second, and third microelectronic elements 138a, 142a, and 146a to package substrate 102. Power lines 164a and ground lines 166a may run through CCR 110. Power lines 164a may be electrically connected to a power source and ground lines 166a may be electrically connected to a ground source. Power lines 164a may be further electrically connected to power lines 164b in substrate 102, as well as electrically connected to power lines 164c that extend through interposer 150. Similarly, ground lines 166a may be further electrically connected to ground lines 166b in substrate 102, as well as electrically connected to ground lines 166c extending through interposer 150. This configuration allows for capacitors in the assembly 100 to be connected to a power source and a ground source, so as to supply power to one or more of the microelectronic elements in the assembly 100. An interposer 150 is not required in the assembly and the first, second, and third microelectronic elements 138a, 142a, and 146a may instead be directly bonded to substrate 102. Bonding material, such as solder balls 120 may be used to bond and electrically interconnect interposer 150 to substrate 102, as well as to bond and electrically interconnect CCR 110 to substrate 102. Package terminals 108b disposed at bottom surface 106 of substrate 102 provide for further electrical connection of package assembly 100 to other components, such as a PCB. An overmold 157 or the like may be provided over the solder balls throughout the package assembly. An overmold may also be provided over capacitors 126 in assembly 100.

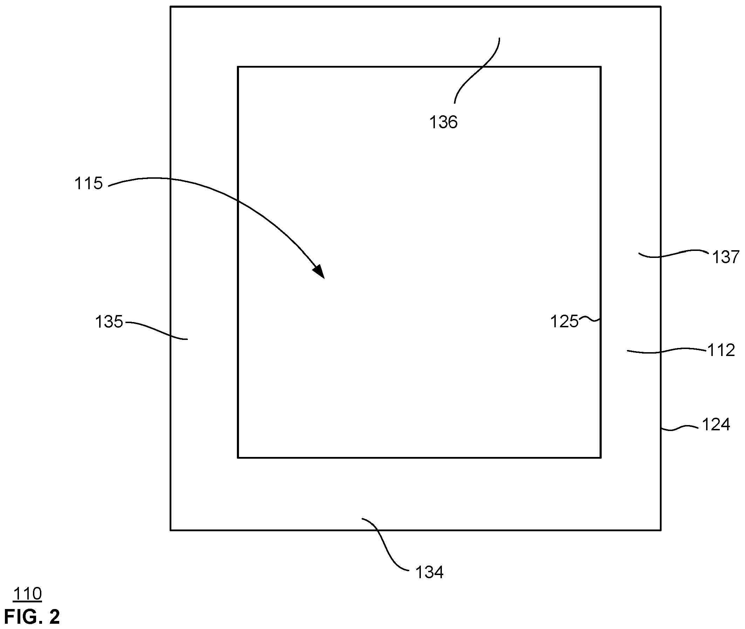

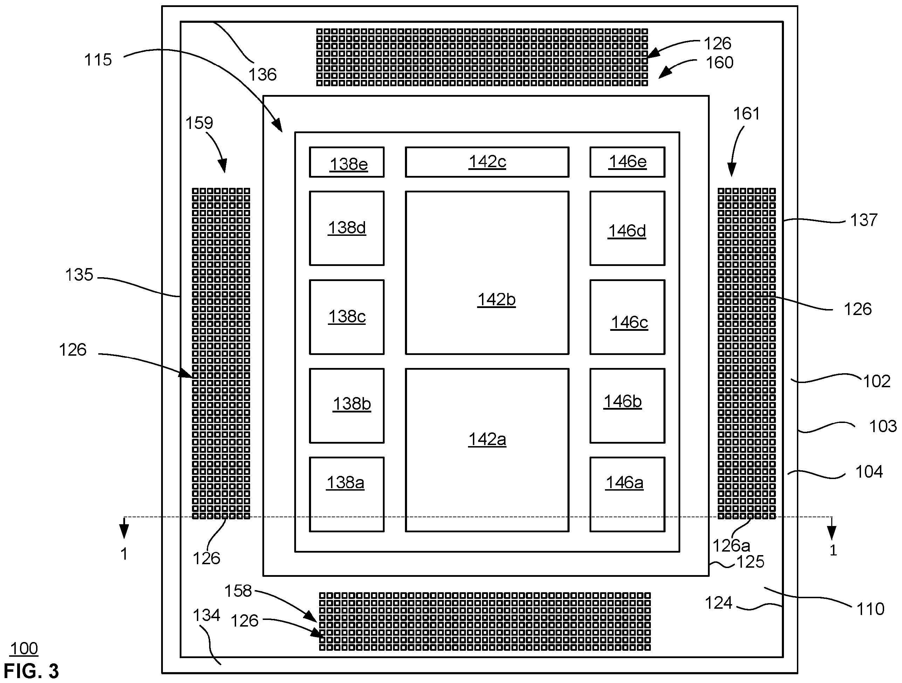

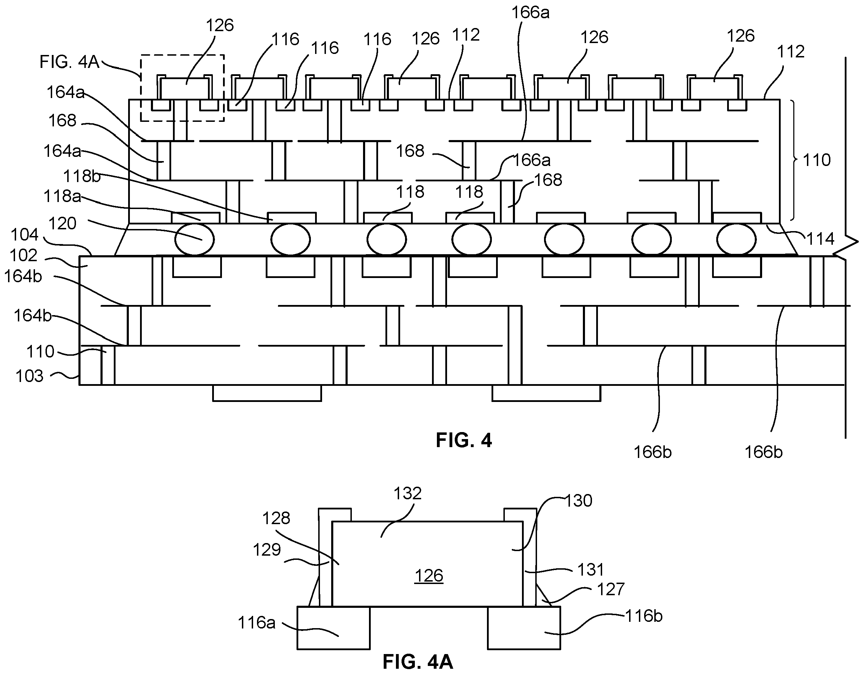

FIG. 2 illustrates a top view of CCR 110 standing alone. FIG. 3 illustrates a top view of assembly 100, including CCR 110. CCR 110 can be manufactured to take on a variety of shapes, but in this example, CCR 110 may have a shape that is similar to the shape of the package substrate. For example, as shown in FIG. 2, CCR 110 is in the shape of a square frame or ring. CCR 110 includes a top surface 112, a bottom surface 114 (as shown in FIG. 4), an outer edge surface 124, and an interior edge surface 125 that extends between the top and bottom surfaces 112, 114 and that further defines the opening 115 of CCR 110. In this example, CCR 110 is contiguous and includes a first side 134, a second side 135, a third side 136, and a fourth side 137. In other examples, CCR 110 can take on a variety of shapes, as will be described in more detail below. CCR 110 may also be comprised of smaller CCR components that are arranged circumferentially around the substrate 102 to collectively form the shape of a ring, a border, a frame, or any other desired shape or configuration, as will also be discussed in more detail below.

CCR 110 may be a multi-layer metallized ("MLM") carrier composed of ceramic material, such as a ceramic having a high coefficient of thermal expansion ("CTE"). In one example, the ceramic material is a low temperature co-fired ceramic ("LTCC"), but in other examples a different type of ceramic can be implemented. In some examples, CCR 110 can be further designed to have a Young's modulus ranging from 75 GPa to 150 GPa, a flexural strength ranging from 150 MPa to 300 MPa, and a CTE ranging from 10-15 ppm/C. In some examples, the Young's modulus may be greater than 75 GPa, and/or the Young's modulus may be greater than 150 GPa. Similarly, the Young's modulus may be less than 50 GPa and/or less than 150 GPa. In one example, CCR 110 may have a Young's modulus of 100 GPa. In some examples, CCR 110 may have a flexural strength greater than 150 MPa, and/or a flexural strength greater than 300 MPa. Similarly, CCR 110 may have a flexural strength less than 300 MPa and/or less than 150 MPa. In one example, CCR 110 may have a flexural strength of 280 MPa. CCR 110 may have a CTE ranging from 8 ppm/K to 17 ppm/K, and/or greater than 8 ppm/K, and/or greater than 17 ppm/K. Similarly, the CTE may be less than 8 ppm/K and/or less than 17 ppm/K. In one example, the CTE may be 12 ppm/K. Common base materials that form CCR 110 can include, without limitation, Aluminum Oxide (Al2O3), Aluminum Nitride (AlN), Zirconia (ZrO2), Silicon Oxide (SiO2) and Silicon Nitride (SiN). Based on these ceramics, the CTE and modulus can be varied, as needed. When CCR is composed primarily of a ceramic substrate with metallization of the surfaces (discussed further below), the properties will be closer to those of the ceramics themselves. For example, Al2O3 may have a CTE ranging from 6-9 ppm/C, a Young's modulus of 250-300 GPa; AlN may have a CTE of 4-6 ppm/C and a Young's modulus of 300-350 GPa.

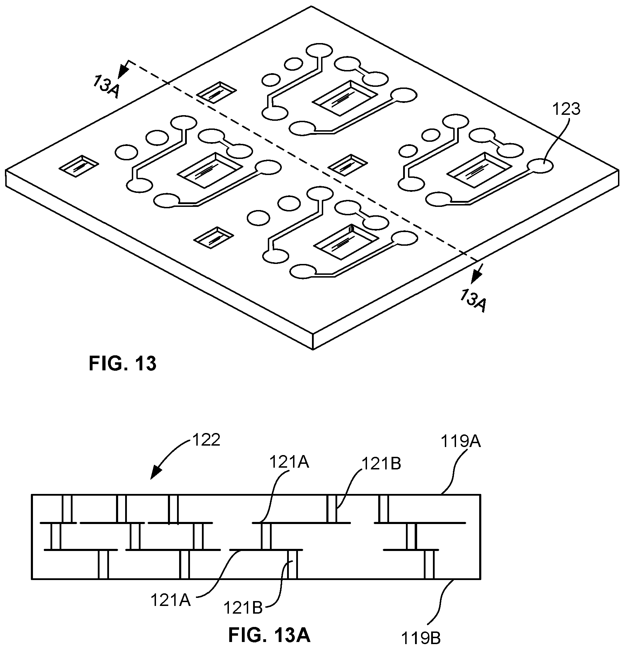

CCR 110 may be formed from and cut out of a larger MLM carrier structure, such as the schematic example of MLM carrier structure 122 shown in FIG. 13, and the cross-sectional view of FIG. 13 A. Various methods can be utilized to form underlying MLM carrier structure 122 from which the CCR 110 will be obtained. In one example, ceramic package substrate technology is utilized to form the MI,M carrier structure 122. For example, a plurality of "green sheets," such as a matrix of organic materials with ceramic powder, may be punched with openings for vias. Conductive material for traces may be applied to the surface of each green sheet and used to fill the vias. The plurality of green sheets may be stacked one on top of the other, and laminated and co-fired to form the MLM carrier structure 122. The ceramic material of CCR 110 may be LTCC, but any other type of ceramic material may also be utilized. Contact pads 123 may also be provided at the top and bottom surfaces of the MLM carrier structure 122. The result may be a MI,M carrier structure 122, which, in this example, may be in the form of a planar carrier sheet. CCR 110 may be cut away from the MLM carrier structure 122 so as to be in the shape of a square frame which will possess the same attributes as MLM carrier structure 122. As shown, MLM carrier structure 122 may include a top surface 119A, a bottom surface 119B, and electronic wiring layers 121A and vias 121B extending between and through the top and bottom surfaces 119A, 119B. MLM carrier structure 122 may be cut into the desired shape of CCR 110 using known methods, such as stamping, slicing, sawing, and the like. In another example, MLM carrier structure 122 may instead be formed by starting with an already-formed ceramic substrate that is subsequently drilled to form vias and plated on both sides to form pads.

In the package assembly 100, as shown in FIG. 4, which illustrates an enlarged area of FIG. 1, CCR 110 may be positioned so that CCR 110 extends adjacent a peripheral edge 103 of substrate 102, as well as around each of the first, second, and third microelectronic elements 138a, 142a, and 146a, as well as around other microelectronic elements 138b-e, 142b-c, and 146b-e in assembly 100 (FIG. 3). In this example, CCR 110 extends contiguously around the microelectronic elements (138a-e, 142a-c, and 146a-e) in the package along top surface 104 of substrate 102. As shown, outer edge 124 of CCR 110 is spaced away from the outer peripheral edge 103 of substrate 102 and an inner edge 125 of CCR 110 is adjacent an outer edge of the first, second, and third microelectronic elements 138a-e, 142a-c, and 146a-e.

Dedicated power planes or lines and dedicated ground planes or lines are disposed throughout CCR 110. As shown in FIG. 4, power lines 164a and ground lines 166a extend in horizontal directions across CCR 110. Vias 168 may also be used to interconnect respective power lines 164a together, as well as interconnect ground lines 166a. Vias 168 may be openings with conductive material therein which extend through CCR 110 to provide an electrical interconnection between conductive components. Upper CCR pads 116 may be disposed at a top surface 112 of CCR 110 and lower CCR pads 118 may be disposed at a bottom surface 114 of CCR 110. Upper CCR pads 116 and lower CCR pads 118 may be further electrically connected to one another through power lines 164a and one or more ground lines 166a that extend through CCR 110. Some of the upper CCR pads 116 may be ground contacts and other of the upper CCR pads may be power contacts. At least one of the lower CCR pads 118 may be a ground contact 118a and another of the lower CCR pads 118 may be a power contact 118b. It is to be appreciated that as used herein, when a component is described as being "disposed at" or "on" a surface, this means that the component may be positioned on a surface, below a surface, partially recessed so that such component is above and/or below the surface, or positioned relative to the surface so as to provide a point of electrical connection between the component and another device.

Capacitors are typically designed to store electrical energy in an electrical field by accumulating electricity on two closely spaced surfaces that are insulated from one other by a dielectric material. Capacitors 126 may be bonded to CCR 110. In this example, capacitors 126 are bonded to upper CCR pads 116. Capacitors are passive electronic components with two terminals or electrodes. In this example, the capacitors may be horizontal capacitors, as commonly known, with electrode ends parallel to the top surface 112 of the CCR 110. As shown in FIG. 4A, each capacitor 126 may have a first end 128 and a first conductive end plate 129 extending around first end 128, as well as a second end 130 and a second conductive end plate 131 extending around second end 130. A dielectric material 132 may be disposed between first conductive end plate 129 and second conductive end plate 131 in order to insulate the first and second end plates 129, 131 from each other. Either the first conductive end plate 129 or the second conductive end plate 131 will be electrically connected to a ground source and the other end will be electrically connected to a power source. Each of the first and second ends 128, 130 may be respectively bonded to one of the upper CCR pads 116. In this example, first end 128 and first conductive end plate 129 may be bonded to a ground contact 116a and second end 130 and second end plate 131 may be bonded to a power contact 116b. Ground contact 116a at top surface of CCR 110 may be further connected to ground lines in CCR 110, as well as ground contact 118a at the bottom surface of CCR 110.

Incorporating CCR 110 into assembly 100 provides for an enlarged surface area to which numerous capacitors may be bonded and arranged. This can multiply the number of capacitors that are available to provide power to microelectronic elements or other components within the chip package assembly. For example, referring back to FIG. 3, capacitors 126 may be arranged in arrays along CCR 110. Capacitors 126 are bonded to CCR 110 and extend along at least a portion of the first side 134, second side 135, third side 136, and fourth side 137 of CCR 110. As shown, a first array 158 of capacitors 126 is positioned along a central portion of first side 134 of CCR 110; a second array 159 of capacitors 126 is positioned along a central portion of second side 135 of CCR 110; a third array 160 of capacitors 126 is positioned along a central portion of third side 136 of CCR 110; and a fourth array 161 of capacitors 126 is positioned along a central portion of fourth side 137 of CCR 110. Each of the first through fourth arrays 158, 159, 160, and 161 may be an 8 x 45 array of capacitors, such that each array has 360 capacitors. But, the number and arrangement of capacitors 126 can vary widely and capacitors 126 may be arranged or disposed at a surface CCR 110 in numerous other configurations. For example, the arrangement of capacitors 126 on each of the first, second, third, and fourth sides 134, 135, 136, and 137 does not need to be identical or similar to one another, and there may be package configurations where no capacitors are disposed at one or more of the first, second, third, and fourth sides 134, 135, 136, and 137.

Additional components may be electrically interconnected and/or directly bonded with CCR 110. For example, the central positioning of the first, second, third, and fourth arrays 158, 159, 160, and 161 on the first, second, third, and fourth sides 134, 135, 136, and 137 of CCR 110 leaves corners of CCR 110 open and available for interconnection with other package components to be provided thereon, such as a heat spreader and the like. In other examples, capacitors 126 may extend continuously all around CCR 110, or in any of a variety of configurations.

CCR 110 may be attached to substrate 102 using solder balls, a screen-printed pattern of solder paste, a conductive adhesive, or other desired materials for electrically interconnecting CCR 110 with substrate 102. As shown in FIG. 4, solder balls 120 may be used to electrically interconnect CCR 110 and substrate 102; in this example, solder balls 120 directly bond CCR 110 to substrate 102. Solder can provide a reliable and high-performance electrical connection between CCR 110 and substrate 102. When BGA technology is used, the size and pitch of the solder balls 120 can be varied to meet the design requirements for electrical performance and warpage control.

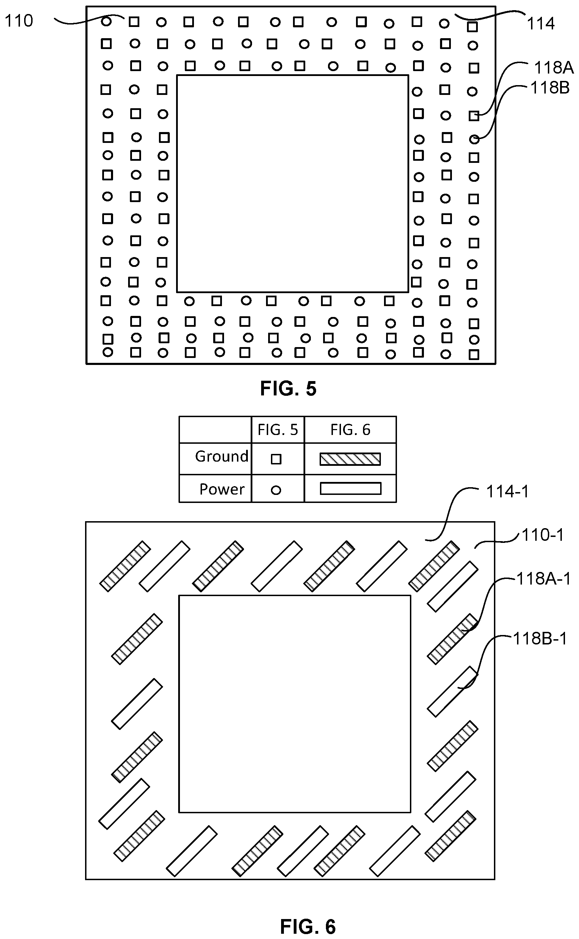

FIG. 5 illustrates bottom surface 114 of CCR 110 (removed from the assembly), and an example pattern of contact pads, such as BGA pads or contacts 118A, 118B configured in a BGA pattern. BGA contacts 118A can take on any shape, but for ease of discussion are illustrated as either a square or circle. BGA contacts 118A represented by a square may provide a ground connection and BGA contacts 118B represented by a circle may provide a power connection. The BGA contacts 118A, 118B provide a desired pattern for the solder balls 120 to be provided on CCR 110. In another example, patterns of solder paste may be disposed at bottom surface 114 of CCR 110. FIG. 6 illustrates another example pattern of contacts, in which elongated contact pads 118A-1, 118B-1 are patterned and disposed at bottom surface 114-1 of CCR 110-1. In this example, the hatched elongated contact pads 118A-1 provide a ground connection and the non-hatched elongated contact pads 118B-1 provide a power connection. In other examples, any variety of screen-printed patterns of solder paste may be utilized.

Referring back to FIG. 1, first, second, and third microelectronic elements 138a, 142a, and 146a can be any type of microelectronic elements and can include active and/or passive components and semiconductor chips. In this example, first and third microelectronic elements 138a, 146a are HBM chips and the second microelectronic element is an IC chip. First, second, and third microelectronic elements 138a, 142a, and 146a may be electrically connected to substrate 102. In this example, an interposer 150 may provide electrical interconnections between substrate 102 and the first, second, and third microelectronic elements 138a, 142a, and 146a. Interposer 150 may be comprised of various materials, such as silicon, glass, PCB, or other materials; in this example, interposer 150 may be comprised of silicon.

As shown, interposer 150 may have a top surface 152, a bottom surface 154, and a plurality of through silicon vias 156 extending between the top and bottom surfaces 152, 154. Bond pads (not shown) may be provided at the top surface 152 and bottom surface 154 of interposer 150. Solder balls 120 may be used to electrically interconnect contact pads 140 positioned at front surface 139 of the first microelectronic element 138a to pads (not shown) of interposer 150. Similarly, respective contact pads 144, 148 at front surfaces 143, 147 of second and third microelectronic elements 142a, 146a are electrically connected and bonded through solder balls 120 to pads (not shown) at top surface 152 of interposer 150. Contact pads (not shown) at bottom surface 154 of interposer 150 are electrically connected through solder balls 162 to terminals 108a disposed at top surface 104 of substrate 102. In other examples, in lieu of solder balls, other conductive materials may be used to conductively connect and/or bond any two components in the system. For example, a conductive adhesive or thermal interface material are two non-limiting examples.

The electrical interconnection among CCR 110, substrate 102, and first through third microelectronic elements 138a, 142a, and 146a enables capacitors 126 to supply power to one or more microelectronic elements in the assembly. For example, as shown in FIG. 1, capacitors 126 (as shown across line 1-1 of FIG. 3) may supply power to only first microelectronic element 138a and third microelectronic element 146a. Capacitors 126 may be electrically connected to first and third microelectronic elements 138a, 146a through dedicated power lines 164b and ground lines 166b that run through substrate 102, for example as shown in FIGs. 1 and 4. In other examples, capacitors 126 (as shown across line 1-1 of FIG. 3) may be electrically connected to only the second microelectronic element 142a, which in this example is an IC.

In still other examples, capacitors 126 (as shown across line 1-1 of FIG. 3) may provide power and ground to a combination of different types of chips in the assembly, such as an IC chip (second microelectronic element 142a) and another microelectronic element, such as either or both of the first microelectronic element 138a and the third microelectronic element 146a. The remainder of capacitors 126 can be configured to supply power to any one or more of the first microelectronic element 138a and/or second microelectronic element 142a and/or third microelectronic element 146a, and/or any one of the remaining microelectronic elements 138a-138e, 142a-142c, 146a-146e in assembly 100.

As shown in FIG. 1, CCR 110 has a height H1 that extends along a plane, z-axis or along a vertical axis that extends perpendicular to a top surface of the package substrate. Microelectronic elements 138a-e, 142a-c, and 146a-e each have a height H1, which for ease of discussion for this example are assumed to all be the same height H1. Height H1 is at least as high as the height H2 of each of the microelectronic elements 138a-e, 142a-c, 146a-e in the package assembly 100, and in this example, height H1 is greater than height H2 of each of the microelectronic elements 138a-e, 142a-c, 146a-e.

In other examples, the height H1 of CCR 110 (FIG. 1) can vary to accommodate the height of the microelectronic elements and any additional components in the assembly. For example, in other arrangements where the microelectronic elements in the assembly have increased height or thickness, CCR 110 can be designed so that the CCR 110 has a height H1 that is at least the same or a similar height as the microelectronic elements and/or components in the package assembly. Similarly, additional devices or components may overlie portions of the microelectronic assembly, such as a heat spreader that directly overlies the microelectronic elements and/or additional microelectronic elements that may overlie and be stacked on top of the rear surfaces of the microelectronic elements. Similarly, two or more microelectronic elements may be stacked one on top of the other. Height H1 of CCR 110 can therefore be modified to make adjustments for the height of microelectronic elements in the assembly and/or the inclusion of other components that may overlie the microelectronic elements in an assembly.

Incorporating a capacitor carrier ring with stiffening properties, such as CCR 110, into a chip package assembly can provide additional options for strategically placing capacitors in the chip package assembly for optimum chip and package assembly performance. Capacitors 126 are no longer limited to only being bonded directly to a top surface 104 or bottom surface 106 of substrate 102. For example, instead of positioning capacitors 126 intended to address low frequency needs at a bottom surface 106 of substrate 102, capacitors 126 may be relocated to top surface 112 of CCR 110. This obviates the need to remove solder balls to accommodate the additional capacitors. In some examples, the repositioning of the capacitors 126 can free up space on bottom surface 106 of substrate 102 to be used for other needs, such as providing space for other types of capacitors that may be needed for higher frequency applications and/or other types of capacitors with a shorter connection to the microelectronic elements in the package 100. Moving capacitors 126 to the top of the package assembly 100 can further allow for capacitors of increased height to be more easily incorporated into the package assembly 100, without requiring modifications to the package substrate 102 or a supporting PCB to allow for the increased capacitor height.

In addition to serving as a conductive carrier for capacitors 126, CCR 110 may also function as a stiffener. As previously discussed, traditional stiffeners are independent structural components, such as a metal copper ring, that extend around the substrate and help to minimize warping of the substrate. With CCR 110 being manufactured from a material possessing properties capable of increasing the rigidity and providing warpage control of the package assembly, such as ceramic material, and in this example a LTCC, the resulting structure can help to provide sufficient rigidity in the overall chip package at high temperatures and also possesses a coefficient of thermal expansion ("CTE") that closely matches the CTE of the package substrate or a PCB. The CCR can therefore eliminate the need for a separate structural stiffener and allow space for additional capacitors at the top surface 104 of substrate 102.

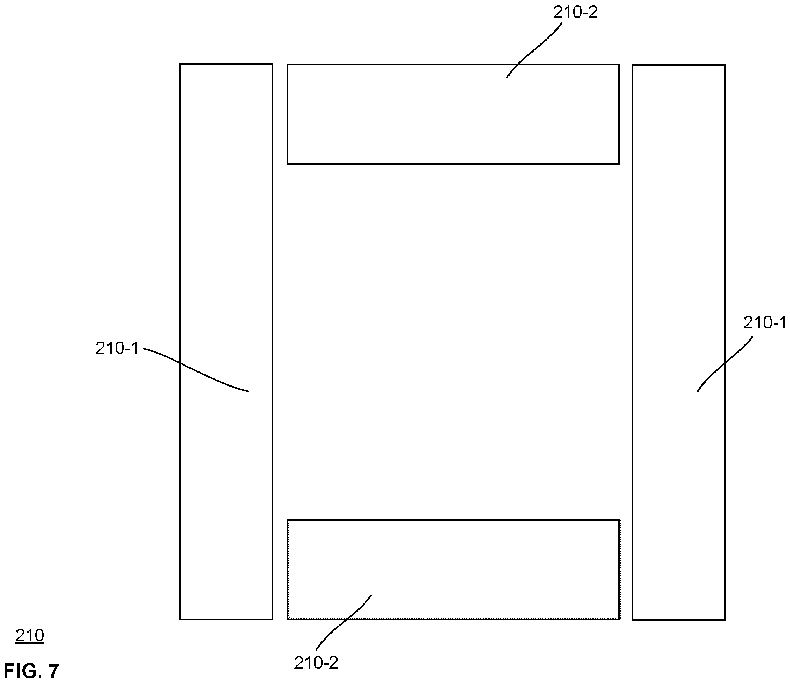

It is to be appreciated that capacitor carriers are not limited to the shape of a ring or a single unitary component. Although example CCR 110 is in the shape of a contiguous and unitary frame or ring, in other examples, a carrier capacitor ring may be composed of multiple discrete and individual CCR components that can be collectively arranged to form any desired shape. For example, as shown in FIG. 7, CCR 210 may be comprised of four individual CCR components that can be collectively arranged to form the shape of a ring or frame. CCR 210 can include two longer rectangular CCR components 210-1 and two shorter rectangular CCR components 210-2.

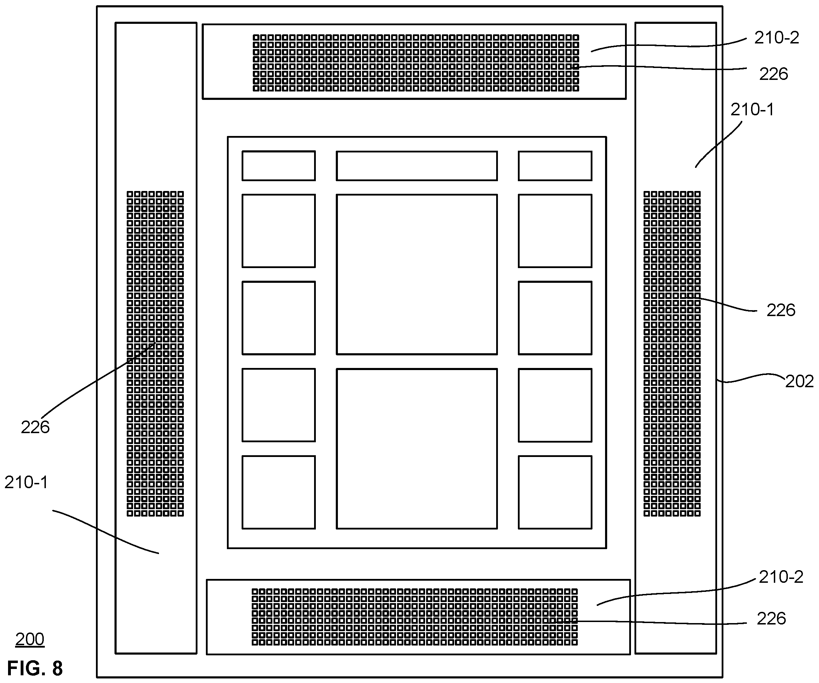

FIG. 8 illustrates a top view of an assembly 200 that incorporates CCR 210. Other than the CCR components collectively forming the shape of CCR 210, assembly 200 is otherwise identical to assembly 100 and includes identical components, component and package characteristics, and variations thereof that are not described again for brevity. As shown, longer components 210-1 are positioned on the left side and the right side of the package assembly 200. The two longer components 210-1 are spaced apart from one another by two shorter components 210-2. The longer components 210-1 and shorter components 210-2 are arranged end-to-end along the top surface 204 of substrate 202 and around microelectronic elements in the package. Arrays of capacitors 226 are arranged on a central portion of each of longer components 210-1 and shorter components 210-2. In still other examples, each of longer components 210-1 and shorter components 210-2 can be further divided into smaller components, such as longer components 210-1 and shorter components 210-2 being divided in half or by one-third.

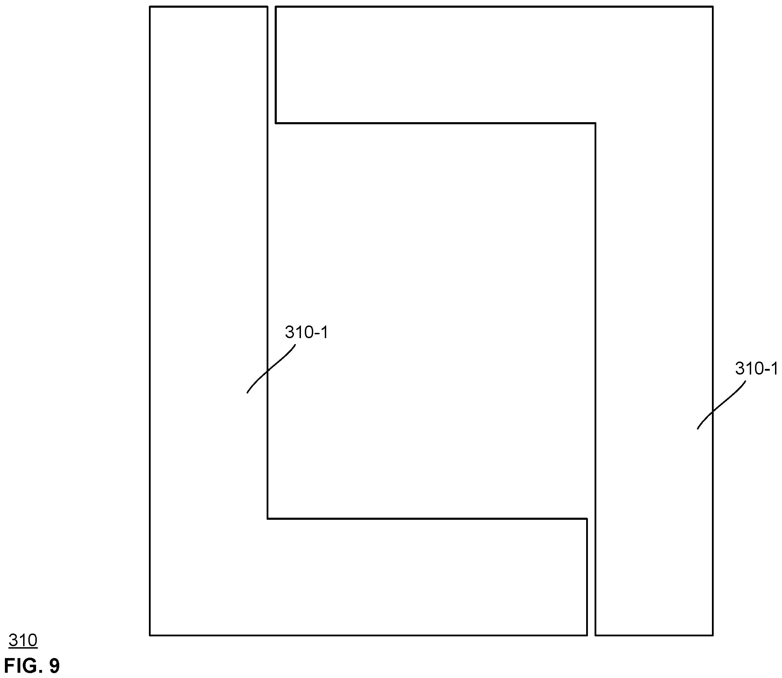

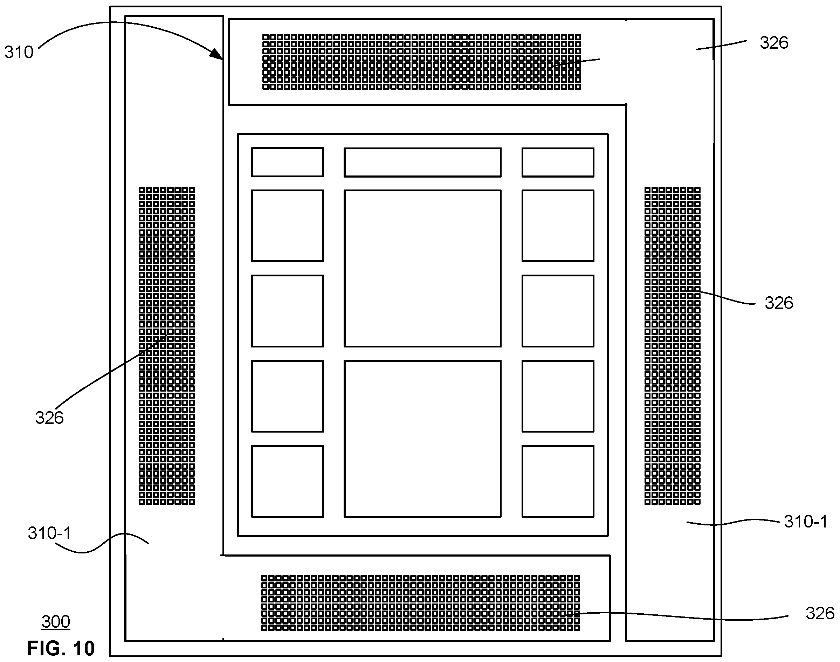

FIG. 9 illustrates another example chip capacitor carrier ring, CCR 310. As shown, CCR 310 can be formed from a combination of two CCR components 310-1. As shown, each CCR component 310-1 is in the shape of the letter "L". FIG. 10 illustrates a top view of an assembly 300 that incorporates CCR 310. Other than CCR 310 being comprised of smaller and distinct CCR components 310-1 that collectively form the shape of CCR 310, assembly 300 is otherwise structurally identical to assembly 100 and includes identical components, component and package characteristics, and variations thereof that are not described again for brevity. As shown, the two L-shaped CCR components 310-1 are inverted to form the shape of a square. Capacitors 326 are arranged in arrays disposed at the top surface 312 of CCR 310 and can be electrically connected to microelectronic elements in the package through electrical routing in CCR 310.

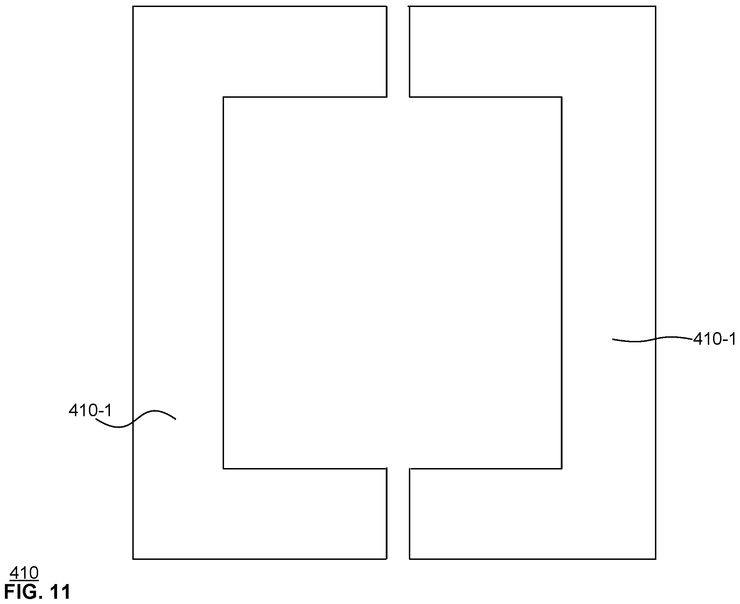

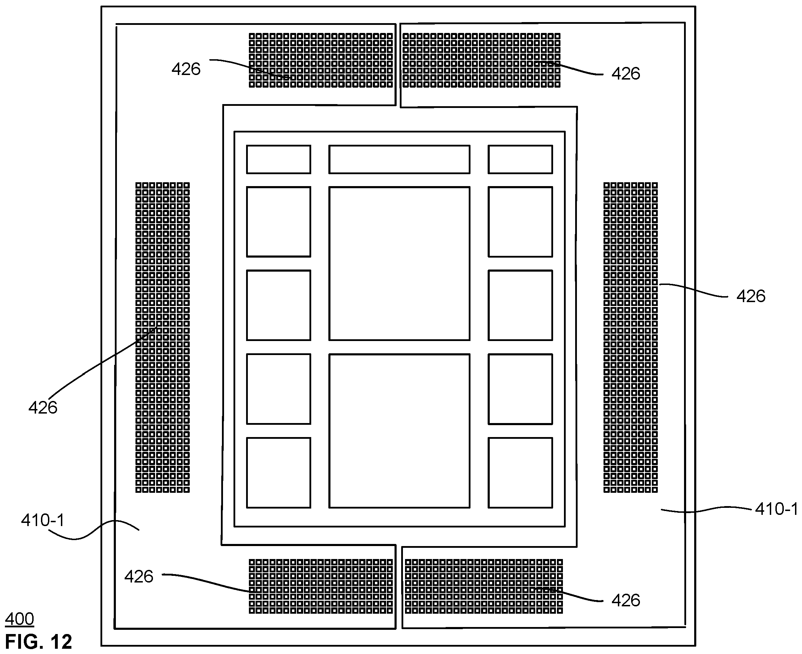

FIG. 11 illustrates another example chip capacitor carrier ring CCR 410, in which CCR 410 is formed from a combination of two CCR components 410-1. Each CCR component 410-1 may be in the shape of the letter "C." FIG. 12 illustrates a top view of a chip package assembly 400 that incorporates CCR 410. Other than the shape of the CCR components, which collectively form the overall shape of CCR 410, assembly 400 may be otherwise structurally identical to assembly 100 and includes identical components, component and package characteristics, and variations thereof that are not described again for brevity. In this example, two C-shaped CCR components 410-1 face one another in order to collectively form the shape of a square frame. Capacitors 426 are arranged in arrays disposed at the top surface 412 of CCR 410 and extend around microelectronic elements in assembly 400.

In an example where the CCR is manufactured in the shape of a single unitary frame or ring, such as CCR 110 (*e.g.,* FIG. 2), the ring shape can be cut out from a larger MLM carrier structure, such as the MLM carrier structure 122 previously discussed with regard to FIG. 13. Cutting out the ring shape of CCR 110 from MLM structure further requires cutting out a central opening defined by the inner edge 125 of the CCR 110. The central opening cutout results in excess and unused portions of the MLM carrier structure 122 (*i.e*., the portion of the MLM carrier structure that is cut out to form the central opening in the frame or ring).

Where the CCR is instead formed from a plurality of individual CCR components that collectively form a desired shape (e.g., FIGS. 7, 9, 11), each of the components can also be cut out from a larger MLM carrier, such as MLM carrier structure 122. However, the shapes and smaller sizes of these components can allow for minimal waste of the MLM carrier, as well as easy processing and easy storage of the cut-out CCR components. For example, with reference back to FIG. 7, multiple longer rectangular CCR components 210-1 and multiple shorter rectangular CCR components 210-2 can be cut from a larger MLM carrier structure, such as the MLM carrier structure 122 shown in FIGS. 13 and 13A, as previously described herein. As the shape of longer rectangular CCR components 210-1 and multiple shorter rectangular CCR components 210-2 components are symmetrical and possess no recesses or openings, maximum use of MLM carrier structure 122 can be achieved. The shape of longer rectangular CCR components 210-1 and multiple shorter rectangular CCR components 210-2 also lends itself to easy storage. Moreover, the smaller segments can facilitate easier alignment with connections on the package substrate, as compared to a single and/or unitary CCR, where simultaneous alignment of all CCR connections are required at the same time.

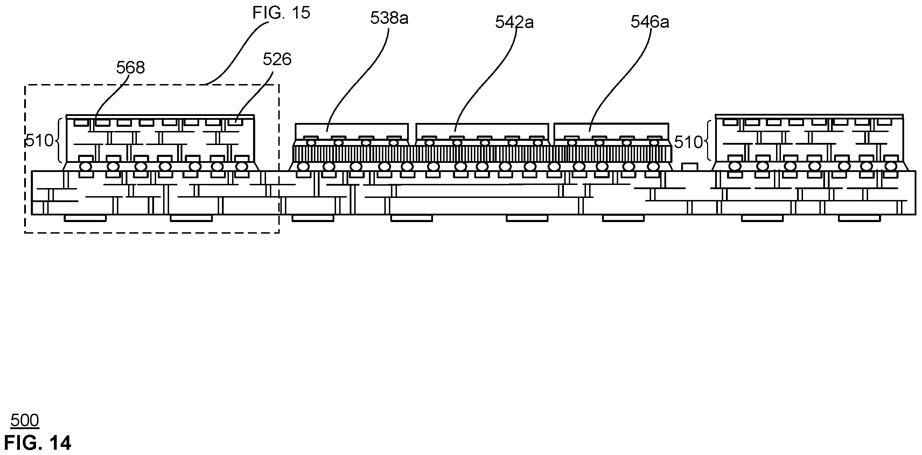

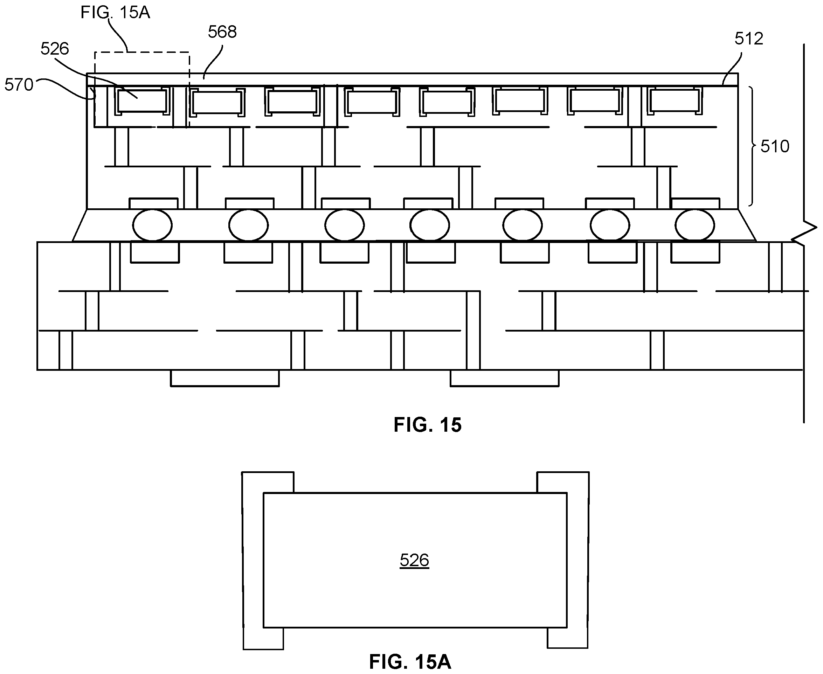

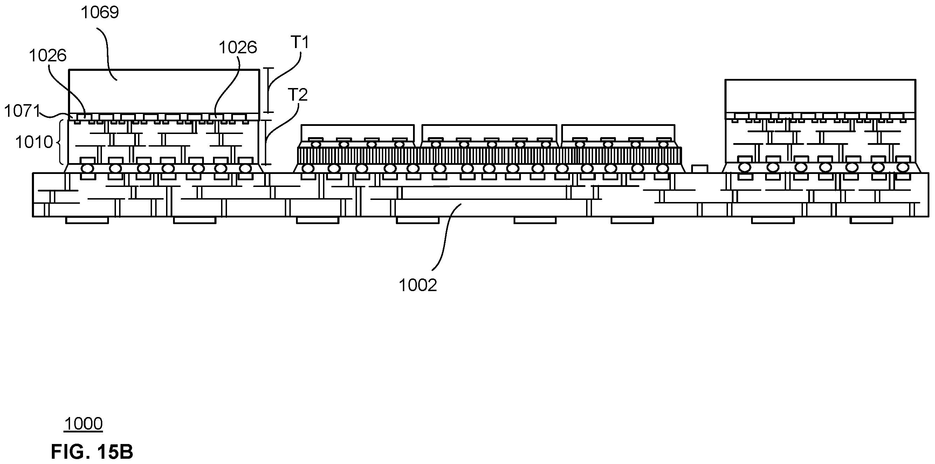

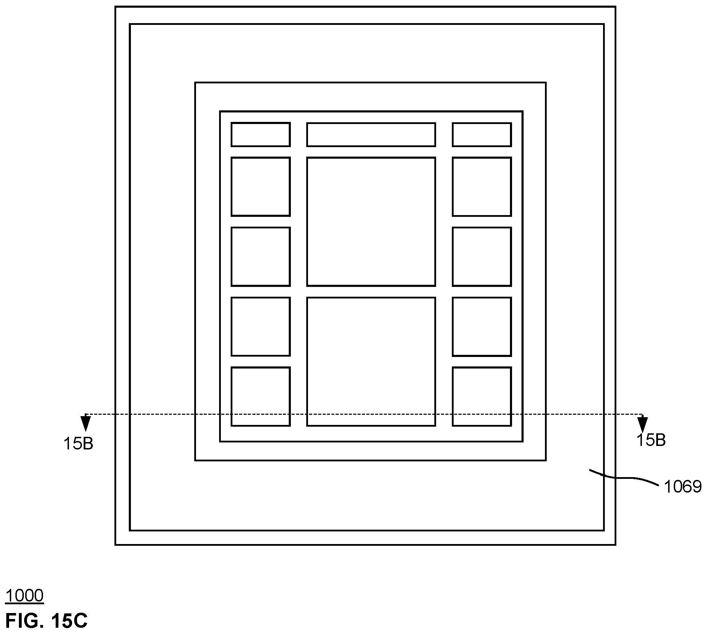

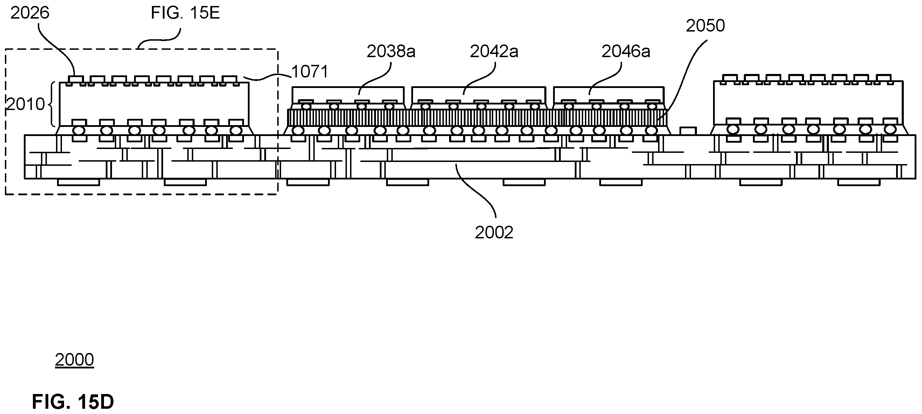

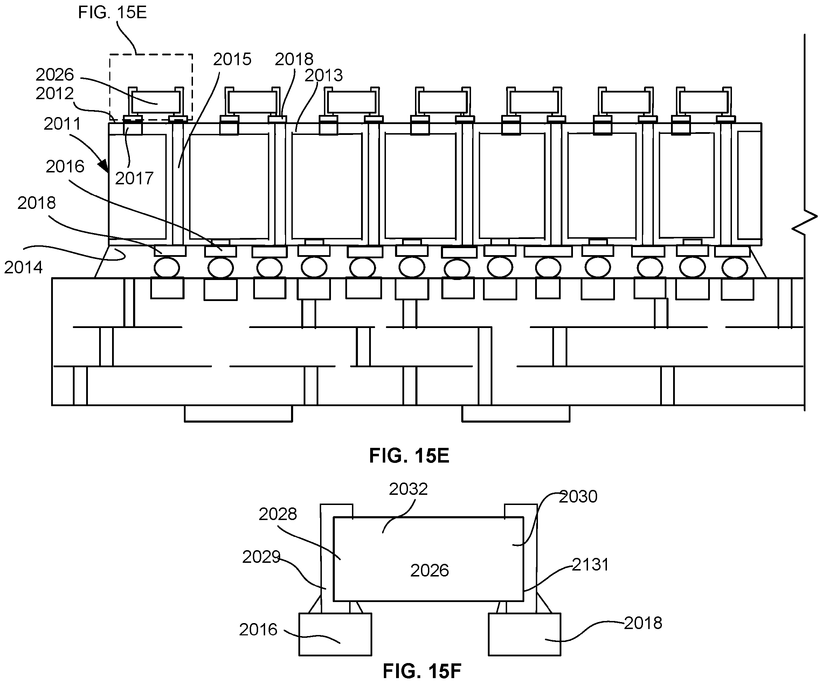

FIG. 14 and the enlargements of FIGS. 15 and 15A illustrate another example microelectronic element package assembly 500, which incorporates CCR 510. In this example, capacitors 526 do not overlie a top surface 512 of CCR 510, but instead are at least partially recessed within CCR 510. As shown, CCR 510 may be a multi-layer ceramic carrier formed from a MLM carrier structure 122, as previously discussed with regard to FIG. 13. CCR 510 may again be in the shape of a contiguous square or frame, as shown in FIG. 2. In this example, capacitors 526 are shown embedded or otherwise fully recessed within CCR 510. Capacitors 526 may be identical to the capacitors previously described herein.

When a certain stiffness in the package assembly 500 is desired but the properties of CCR 510 are insufficient to provide the desired stiffness, a separate stiffening element may be introduced into the package that can provide additional strength or rigidity to assembly 500. Stiffening element 568 is one example of a stiffening structure that can enhance stiffness of the overall multi-chip assembly 500. As shown, stiffening element 568 overlies capacitors 526 and CCR 510. Bottom surface 570 of stiffening element 568 may be directly bonded to top surface 512 of CCR 510 using known methods and materials, such as a thermal interface material, solder, conductive adhesive, or the like. Stiffening element 568 may be composed of a rigid material, including but not limited to polyimide, FR-4, aluminum, stainless steel, and copper. In this example, stiffening element 568 may be composed of copper and have a shape that is substantially similar to the shape of CCR 510. In other examples, the stiffening element may instead be a planar sheet that extends across the top surfaces of all CCR components, in addition to microelectronic elements 538a, 542a, 546a in the package. The remaining components of assembly 500 are otherwise identical to components of assembly 100 and the components, component and package characteristics, and variations thereof are not described again for brevity.

In some examples, instead of providing a CCR composed of a ceramic material, the CCR may instead be a PCB, which in combination with another stiffener element can help to achieve the desired flexural stiffness to minimize warpage in the packages assembly, while also providing an electrical connection between the chip capacitors and microelectronic elements in the package assembly. For example, with reference back to FIGS. 1-15, instead of CCR 110, CCR 210, CCR 310, CCR 410, or CCR 510 being composed of a ceramic material, CCR 110, CCR 210, CCR 310, CCR 410, or CCR 510 can instead be a PCB or composed and structurally similar to a PCB. However, simply incorporating a PCB into such embodiments alone will not achieve a package assembly with the desired stiffness for the CCR and overall package assembly. A secondary stiffener element can be used in combination with a CCR composed of a PCB to achieve the desired stiffness.

The secondary stiffener may be composed of any number of materials, including without limitation metals, alloys, ceramics and PCB. In one example, to achieve a desired flexural stiffness when the CCR is composed of a PCB, a second stiffener element composed of a PCB may be joined to the CCR and the capacitors to provide a desired flexural stiffness. Flexural or bending stiffness depends on the modulus of elasticity and the thickness of the material. Bending stiffness is proportional to the cube of the thickness, which means increasing the thickness of the PCB by two times increases the bending stiffness by eight times. For example, with reference to FIG. 15B, a microelectronic package assembly 1000 may be identical to the assembly of FIGS. 1-5 previously disclosed herein, except that assembly 1000 includes a CCR composed of a PCB, referred to herein as a PCB CCR 1069 and a secondary stiffener 1069 overlies and is attached to CCR 1010. The secondary stiffener 1069 may be attached or laminated to PCB CCR 1010 by known means, such as use of a joinder material 1071, such as an encapsulant, adhesive, thermal interface material, or any means for attaching the secondary stiffener 1069 to PCB CCR 1069. As shown, the joinder material 1071 will encapsulate the capacitor and bond secondary stiffener 169 to PCB CCR. In the top view of the package assembly 1000 shown in FIG. 15C, capacitors 1026 overlying PCB CCR 1010 will be hidden from view by secondary stiffener 1069. The thickness T1 of secondary stiffener 1069 can therefore be varied to achieve the desired flexural stiffness of the combined PCB CCR 1010 and the secondary stiffener 1069 of the package assembly 1000. In this example the thickness T1 of secondary stiffener 1069 and the thickness T2 of PBC CCR 1010 may be the same, but in other examples they may differ.

In some examples, when manufacturing the assembly 100, capacitors 1026 may be joined and bonded to CCR 1010 prior to joining PCB CCR 1010 to substrate 1002. This can allow for any additional processing of PCB CCR 1010 that may be required to accommodate capacitors 1026 before PCB CCR 1010 is attached to substrate 1010. This can help to maintain the overall integrity of substrate 1002, since no additional processing of substrate 1002, such as routing cavities within the substrate, will be needed to accommodate capacitors 1026 within assembly 1000.

FIG. 15D is another example microelectronic package assembly 2000. The assembly 2000 is structurally similar to the previous examples discussed in FIGS. 1-15, except that the main body of the CCR is primarily comprised of a metal material with vias extending therethrough, as described in further detail below. As in the previous examples, assembly 2000 includes a package substrate 2002, a capacitor carrier, such as an example CCR 2010 that supports capacitors 2026, and an interposer 2050 that electrically connects first, second, and third microelectronic elements 2038a, 2042a, and 2046a to package substrate 2002. Further details regarding these other features of assembly 2000 are similar and are not described again for brevity.

With reference to FIG. 15E, instead of being comprised of a ceramic material, CCR 2010 may include a main body 2011 comprised of a metal material, including, without limitation, copper or copper alloys that include aluminum or stainless steel. CCR 2010 may take on any shape, such as those previously described herein. Since the bulk of the metal comprising CCR 2010 is conductive, it may serve as a ground. Ground contacts 2016 may be provided at the top surface 2012 and bottom surface 2014 of CCR 2010. Ground vias 2017 may join ground contacts 2016 to a ground source, which in this example is main body 2011 of CCR 2010. Conductive vias 2015 may extend through top surface 2012 and bottom surface 2014 of main body 2011 and provide an interconnection between power contacts 2018 at the top surface 2012 and bottom surface 2014 of CCR 2010. Dielectric material 2013 or other processing materials may be provided to insulate vias 2015 from the metal or conductive connections within the remainder of main body 2011.

Assembly 2000 provides for a configuration where capacitors 2026 can be connected to a power source and a ground source, so as to supply power to one or more of the microelectronic elements in the assembly 2000. As in previous examples, and as shown in FIG. 15F, each capacitor 2026 may have a first end 2028 and a first conductive end plate 2029 extending around first end 2028, as well as a second end 2030 and a second conductive end plate 2031 extending around second end 2030. A dielectric material 2032 may be disposed between first conductive end plate 2029 and second conductive end plate 2031 in order to insulate the first and second end plates 2029, 2131 from each other. One end of the capacitor will be connected to ground and the other end will be connected to power. In this example, first conductive end plate 2029 will be electrically connected to a ground contact 2016 and ground source and the other second conductive end plate 2131 will be electrically connected to power contact 2018 and a power source. Each of the first and second ends 2028, 2030 may be respectively bonded to the ground contact 2016 and power contact 2018. Solder 127 and the like can be used to bond chip capacitors 2026 to ground contacts 2016 and power contacts 2018.

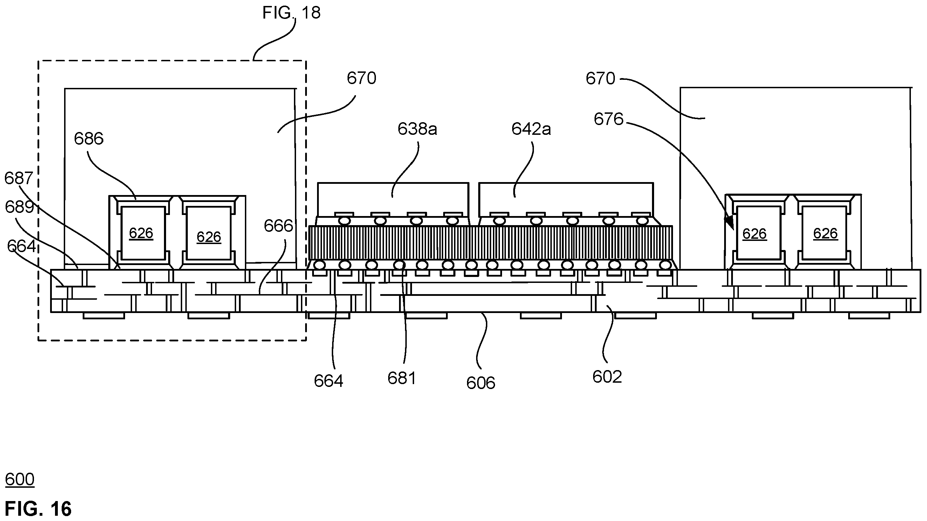

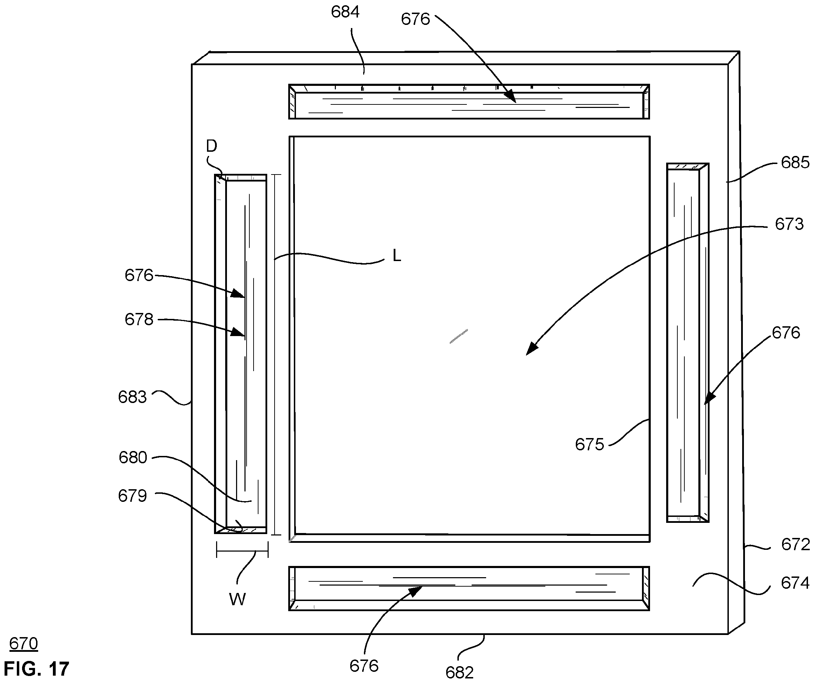

FIG. 16 illustrates an example microelectronic package assembly 600 that does not include a CCR, but instead includes a stiffening element 670 configured to receive and function as a ground connection or terminal for capacitors 626. As shown in FIG. 17, in which stiffening element 670 has been removed from assembly 600, stiffening element 670 may be a unitary and monolithic structure composed of a material that can increase stiffness and rigidity in the package assembly. Examples of such materials include, but are not limited to polyimide, FR-4, aluminum, stainless steel, and copper. Stiffening element 670 includes top surface 672, bottom surface 674, central opening 673, and recesses or pockets 676 that extend between top surface 672 and bottom surface 674. Central opening 673 extends through both top surface 672 and bottom surface 674 and is defined by an internal edge 675 that extends around and defines central opening 673. In this example, pocket 676 further includes opening 678 at bottom surface 674, intermediate surface 680, and walls 679 that extend from opening 678 to intermediate surface 680. Each pocket 676 will have a length L, a width W, and a depth D that can be sized to receive a desired number of capacitors 626.

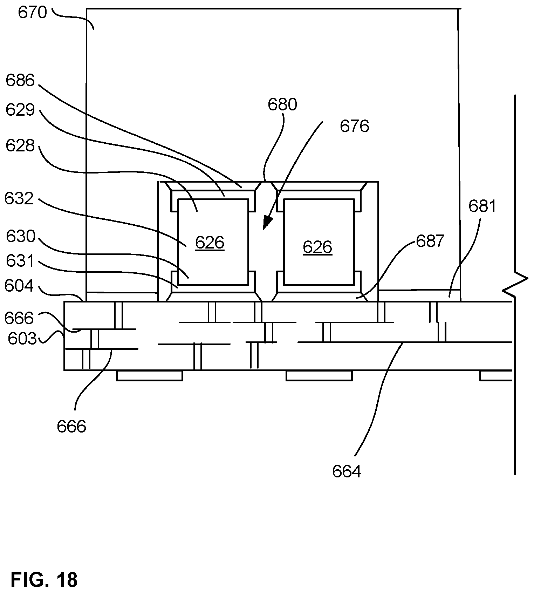

Stiffening element 670 may be manufactured in the shape of a square frame or ring and includes a first side 682, a second side 683, a third side 684, and a fourth side 685. Stiffening element 670 can be manufactured to achieve any shape or size needed to meet specific needs of the package, including but not limited to those configurations previously described herein. As shown in FIG. 18, stiffening element 670 may be mechanically and electrically attached to substrate 602 with a conductive material 689. Examples of conductive material include without limitation, conductive metal-organic paste, including without limitation, silver-filled epoxy, or reflowable low-temperature melt metal such as solder, Indium, or Gallium. In this example, solder 681 may be used to electrically connect and join stiffening element 670 to substrate 602. Stiffening element 670 may extend around each of the microelectronic elements in the assembly, including microelectronic elements 638a-638d, 642a-642c, 646a-642c.

Arrays of capacitors 626 may be positioned directly within pockets 676 of stiffening element 670. In this example, as best illustrated in FIG. 18, each of the capacitors 626 may have a first end 628 and a first conductive end plate 629 extending around first end 628, as well as a second end 630 and second conductive end plate 631 extending around second end 630. A dielectric material 632 may be disposed between first conductive end plate 629 and second conductive end plate 631 in order to insulate first and second conductive end plates 629, 631 from each other. First conductive end plate 629 may be bonded directly to intermediate surface 680 of stiffening element 670 with a conductive material 686 and second conductive end plate 631 may be bonded directly to pads (not shown) on top surface 604 of package substrate 602 with conductive material 687. Known conductive materials may be utilized to electrically connect and bond first conductive end plate 629 and second conductive end plate 631, including, without limitation, solder, thermal interface material, or other materials disclosed herein.

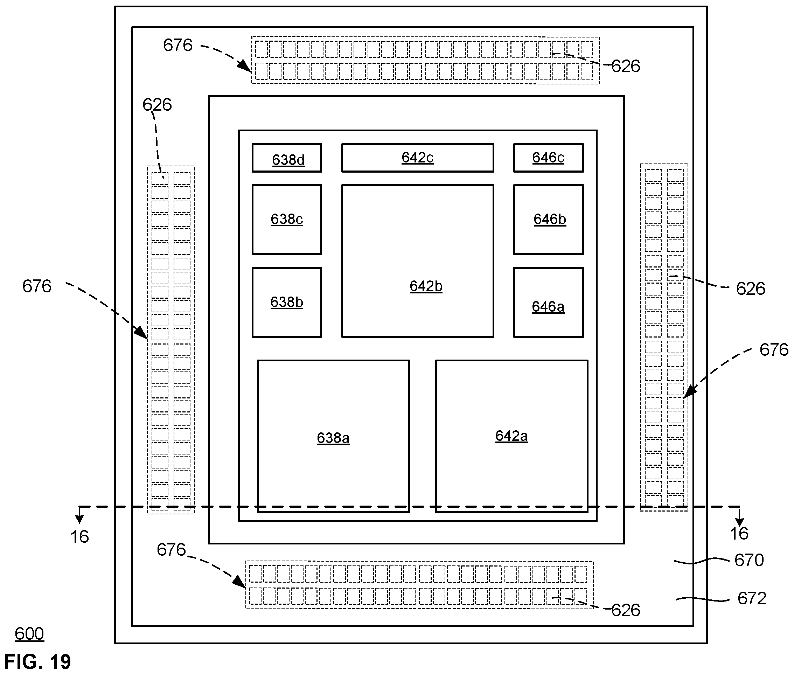

Stiffening element 670 itself may be connected to a ground source and act as a ground terminal to which capacitors 626 may be directly attached. Second conductive end plate 631 may be electrically connected to a power source. Capacitors 626 shown in FIG. 16 (i. *e.,* shown across line 16-16 of FIG. 19) can supply power to first microelectronic element 638a and second microelectronic 642a. The remainder of the capacitors in the system can be designed to supply power to any one of the microelectronic elements 638a-638d, 642a-642c, 646a-642c in assembly 600. In this example, as shown in FIG. 16, capacitors 626 can supply power to first microelectronic element 638a and second microelectronic element 642a; in other examples, capacitors 626 or other capacitors in the assembly 600 may supply power to other microelectronic elements in the assembly 600. As in the previous examples, dedicated power lines 664 and ground lines 666 may extend through substrate 602 and provide a connection between capacitors 626 and first and second microelectronic elements 638a, 642a. In this example, only first and second microelectronic elements appear in this cross section, but in other examples, fewer or more than two microelectronic elements may be included in the package.

Pockets 676 may be sized to receive arrays of capacitors 626. In this example, pockets 676 may have a width sufficient to fit two capacitors 626, a length that extends across the array, and a depth sufficient for capacitors 626 to be embedded within stiffening element 670. FIG. 19 illustrates a schematic top plan view of assembly 600. As capacitors 626 are positioned within pockets 676 and do not appear in the top plan view, they are represented in broken lines. In this example, capacitors 626 are arranged in an array of 2 x 24 around stiffening element 670. In other arrangements, greater or fewer numbers of capacitors 626 may be provided within stiffening element 670 by adjusting the size (e.g., length, width, or height) of pockets 676.

A stiffening element 670 that can function as a ground terminal and that includes recesses or pockets 676 for receiving one or more chip capacitors can allow for the strategic placement of capacitors 626 within the package assembly 600 without taking up additional space on the package substrate 602 or in the overall package assembly 600. Chip capacitors 626 may be relocated from the bottom surface 606 of package substrate 602 to top surface 604. Further, by incorporating chip capacitor 626 into stiffening element 670, BGA on bottom surface 606 of package substrate 602 does not need to be removed to accommodate chip capacitors 626, and chip capacitors 626 may be mounted to top surface 604 of package substrate 602

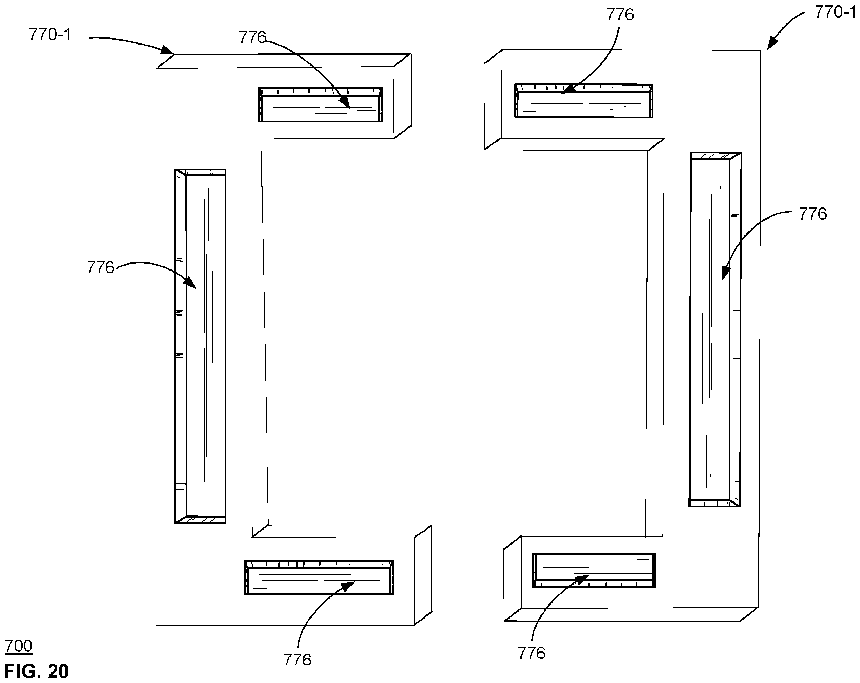

In other examples, instead of the stiffening element being a unitary and contiguous ring, the stiffening element may be a plurality of stiffening element components that collectively extend around the IC chips and the substrate. FIG. 20 illustrates an example stiffening element 700 comprised of two C-shaped stiffening element components 770-1 face one another so as to collectively form the shape of a square frame or a ring. Stiffening elements 770-1 each include recesses 776 that can house capacitors (not shown), as previously disclosed herein. Stiffening elements 770-1 and capacitors can be directly bonded to a substrate package, as previously disclosed herein. Other shapes and sizes for the stiffening element components can be manufactured, including but not limited to elongated rectangular components with recesses, or L-shaped stiffening elements 770-1, such as those shapes previously disclosed herein.

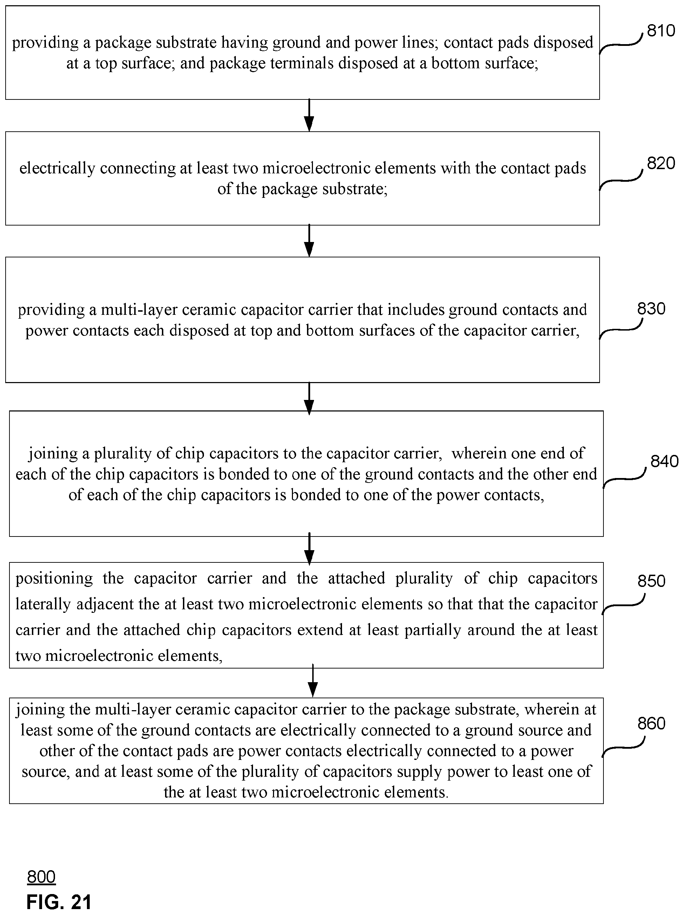

FIG. 21 illustrates an example method for manufacturing a microelectronic element assembly 800. At block 810, a package substrate is provided that includes ground and power lines; contact pads disposed at a top surface; and package terminals disposed at a bottom surface. At block 820, at least two microelectronic elements are electrically connected with the contact pads of the package substrate. At block 830, a multi-layer ceramic capacitor carrier is provided that includes ground contacts and power contacts each disposed at top and bottom surfaces of the capacitor carrier. At block 840, a plurality of chip capacitors are joined to the capacitor carrier. One end of each of the chip capacitors may be joined to one of the ground contacts and the other end of each of the chip capacitors may be joined to one of the power contacts. At block 850, the capacitor carrier and the attached plurality of chip capacitors may be positioned laterally adjacent to the at least two microelectronic elements so that the capacitor carrier and the attached chip capacitors extend at least partially around the at least two microelectronic elements. At block 860, the multi-layer ceramic capacitor carrier may be joined to the package substrate. At least some of the ground contacts may be electrically connected to a ground source and other of the contact pads are power contacts may be electrically connected to a power source. Additionally, at least some of the plurality of capacitors supply power to at least one of the at least two microelectronic elements. In an example method of manufacturing where the plurality of chip capacitors are joined and bonded to the capacitor carrier and thereafter bonded to the ceramic capacitor carrier, this can minimize the number of times the substrate and overall package undergoes reflow, thereby reducing warpage.

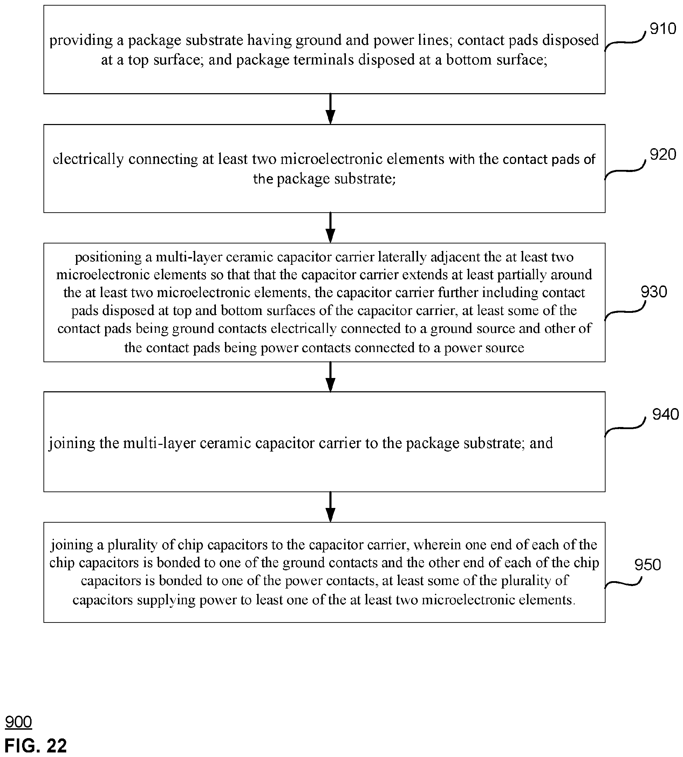

FIG. 22 illustrates another example method for manufacturing a microelectronic element assembly 900. At block 910, a package substrate is provided that includes, without limitation, ground lines and power lines, contact pads disposed at a top surface of the substrate, and package terminals disposed at a bottom surface of the substrate. An example substrate is shown in FIG. 1. At block 920, at least two microelectronic elements may be electrically connected with the package substrate. At block 930, a multi-layer ceramic capacitor carrier is positioned laterally adjacent to the at least two microelectronic elements so that the capacitor carrier extends at least partially around the at least two microelectronic elements. The capacitor carrier can further include contact pads disposed at top and bottom surfaces of the capacitor carrier. At least some of the contact pads are ground contacts electrically connected to a ground source and other contact pads are power contacts connected to a power source. At block 940, the multi-layer ceramic capacitor carrier is bonded to the package substrate. At block 950, a plurality of chip capacitors is bonded to the capacitor carrier. One end of each of the chip capacitors is bonded to one of the ground contacts and the other end of each of the chip capacitors is bonded to one of the power contacts. At least some of the plurality of capacitors supplying power to at least one of the at least two microelectronic elements.

According to one aspect of the disclosure, a microelectronic element package assembly includes a package substrate; at least two microelectronic elements electrically connected to the substrate contacts; a microelectronic element capacitor carrier overlying and joined to the package substrate; and. a plurality of capacitors joined to the capacitor carrier. The package substrate includes a substrate body, substrate contacts disposed at a top surface of the substrate body, package terminals disposed at a bottom surface of the substrate body, and routing lines disposed between the top and bottom surfaces. The microelectronic element capacitor carrier overlies and is joined to the package substrate, The capacitor carrier includes a plurality of ground contacts electrically connected to a ground source; a plurality of power contacts electrically connected to a power source; and capacitor routing lines. At least some of the capacitor routing lines are connected to the plurality of ground contacts and other capacitor routing lines are electrically connected to the plurality of power contacts. The capacitor carrier is positioned laterally adjacent the at least two microelectronic elements and extends at least partially around the at least two microelectronic elements so that an inner edge of the capacitor carrier is adjacent outer edges of the at least two microelectronic elements. A plurality of capacitors may be joined to the capacitor carrier. Each of the plurality of capacitors has a first end joined to one of the plurality of ground contacts and a second end joined to one of the plurality of power contacts. At least some of the plurality of capacitors provide power to at least one of the at least two microelectronic elements; and/or the capacitor carrier includes a low temperature co-fired ceramic; and/or the capacitor carrier further includes a main body, wherein the capacitor routing lines further include dedicated power lines and dedicated ground lines extending throughout the main body of the capacitor carrier, and the routing lines of the package substrate further include capacitor power lines and capacitor ground lines extending throughout the substrate body; and/or the capacitor carrier extends contiguously around the at least two microelectronic elements, the capacitor carrier having a peripheral edge spaced away from a peripheral edge of the package substrate, the capacitor carrier being disposed between the peripheral edge of the package substrate and the outer edges of the at least two microelectronic elements; and/or the capacitor carrier includes a plurality of capacitor carrier components that are positioned around the package substrate to collectively form a shape of a ring, the plurality of capacitor carrier components having an outer peripheral edge spaced away from a peripheral edge of the package substrate; and/or the plurality of capacitors are joined to a top surface of the capacitor carrier and arranged in arrays across the top surface of the capacitor carrier; and/or the microelectronic assembly further includes a heat spreader overlying the plurality of capacitors; and/or the heat spreader further overlies the at least two microelectronic elements; and/or others of the plurality of capacitors are electrically interconnected to a second of the at least two microelectronic elements; and/or the at least two microelectronic elements include at least three microelectronic elements, wherein at least one of the at least three microelectronic elements is an integrated circuit chip and two of the at least three microelectronic elements are high-performance computing chips; and/or the capacitor carrier includes a material having a coefficient of thermal expansion ranging from 5 ppm / °C to 10 ppm / °C and a Young's modulus ranging from 150 GPa to 350 GPa; and/or the capacitor carrier includes a material having a coefficient of thermal expansion ranging from 10 ppm/ °C to 15 ppm/ °C and a Young's modulus ranging from 50 GPa to 150 GPa; and/or the assembly further includes an interposer that provides an electrical interconnection between the at least two microelectronic elements and the package substrate.

According to another aspect of the disclosure, a microelectronic element package assembly includes a package substrate; an interposer overlying and joined to the package substrate; at least two microelectronic elements electrically connected to the package substrate through the interposer; a capacitor carrier ring ("CCR") overlying the package substrate and extending circumferentially around the at least two microelectronic elements; and a plurality of arrays of capacitors. The CCR may include a material having a coefficient of thermal expansion ranging from 5-15 ppm/ °C and a Young's modulus ranging from 25-350 GPa. The CCR further includes a plurality of ground contacts electrically connected to a ground source and a plurality of power contacts electrically connected to a power source. Each of the plurality of capacitors in the plurality of arrays of capacitors may have a first end joined to one of the plurality of ground contacts and a second end joined to one of the plurality of power contacts. At least some of the plurality of capacitors in one or more of the plurality of arrays of capacitors are electrically connected with one of the at least two microelectronic elements and others of the plurality of capacitors are electrically interconnected with a second of the at least two microelectronic elements through an electrical connection between the CCR and the package substrate; and/or the CCR includes a laminated ceramic material; and/or the CCR includes a printed circuit board and the assembly further includes another printed circuit board joined to the CCR and overlying the plurality of arrays of capacitors; and/or the capacitors are at least partially embedded within the CCR; and/or further including a heat spreader lid overlying the plurality of arrays of capacitors.

According to another aspect of the disclosure, a chip package assembly includes a package substrate having at least one power contact electrically connected to a power source; at least two chips electrically connected to the package substrate; a stiffening element joined to the package substrate and extending at least partially around the at least two chips; and, a plurality of chip capacitors disposed within the at least one pocket. The stiffening element may be electrically connected to a ground source so that the stiffening element is a ground and positioned directly adjacent the at least two chips. The stiffening element may further include at least one pocket. The pocket may include an interior contact surface and interior walls extending around and away from the interior contact surface and terminating in an opening. One end of each of the plurality of chip capacitors may be being joined to the interior contact surface and another end of each of the plurality of chip capacitors may be joined to the power contact; and/or the stiffening element is a monolithic structure; and/or the stiffening element includes at least one of the following materials: a polyimide, a FR-4, an aluminum, a stainless steel, and a copper; and/or the stiffening element further includes copper; and/or the stiffening element extends circumferentially around the at least two chips; and/or further including an interposer interconnecting the at least two microchips to the package substrate; and/or further including a heat spreader lid overlying the top surface of the stiffening element; and/or the stiffening element has a height extending along a plane extending perpendicular to a surface of the package substrate to which the stiffening element is attached and that is greater than or equal to a height of each of the first and second chips in the package.

A method of manufacturing a microelectronic element package assembly according to another aspect of the disclosure includes providing a package substrate having ground routing lines and power routing lines, contact pads disposed at a top surface of the substrate, and package terminals disposed at a bottom surface of the substrate; electrically connecting at least two microelectronic elements with the package substrate; positioning a multi-layer ceramic capacitor carrier laterally adjacent the at least two microelectronic elements so that that the capacitor carrier extends at least partially around the at least two microelectronic elements, where the capacitor carrier further includes contact pads disposed at top and bottom surfaces of the capacitor carrier, and at least some of the contact pads are ground contacts electrically connected to a ground source and other of the contact pads are power contacts connected to a power source; joining the multi-layer ceramic capacitor carrier to the package substrate; and joining a plurality of microelectronic element capacitors to the capacitor carrier, wherein one end of each of the capacitors is joined to one of the ground contacts and the other end of each of the capacitors is joined to one of the power contacts, and at least some of the plurality of capacitors supply power to least one of the at least two microelectronic elements; and/or further including joining the capacitor carrier to the contact pads of the package substrate; and/or further including providing a heat sink lid that overlies the plurality of capacitors; and/or further including arranging the plurality of capacitors in arrays across the top surface of the capacitor carrier.

According to another aspect of the disclosure, a method of manufacturing a microelectronic element package assembly includes providing a package substrate that includes ground and power lines, contact pads disposed at a top surface, and package terminals disposed at a bottom surface; electrically connecting at least two microelectronic elements with the contact pads of the package substrate; providing a multi-layer ceramic capacitor carrier that includes ground contacts and power contacts each disposed at top and bottom surfaces of the capacitor carrier; joining a plurality of chip capacitors to the capacitor carrier, wherein one end of each of the chip capacitors is bonded to one of the ground contacts and the other end of each of the chip capacitors is bonded to one of the power contacts; positioning the capacitor carrier and the attached plurality of chip capacitors laterally adjacent the at least two microelectronic elements so that that the capacitor carrier and the attached chip capacitors extend at least partially around the at least two microelectronic elements; and joining the multi-layer ceramic capacitor carrier to the package substrate, wherein at least some of the ground contacts are electrically connected to a ground source and other of the contact pads are power contacts electrically connected to a power source, and at least some of the plurality of capacitors supply power to least one of the at least two microelectronic elements; and/or bonding the capacitor carrier to the contact pads of the package substrate; and/or providing a heat sink lid that overlies the plurality of capacitors.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only some of many possible implementations. Further, the same or similar reference numbers in different drawings can identify the same or similar elements.

According to further aspects of the disclosure, the following examples 1-35 are provided:
1. A microelectronic element package assembly comprising:
   a package substrate having a substrate body, substrate contacts disposed at a top surface of the substrate body, package terminals disposed at a bottom surface of the substrate body, and routing lines disposed between the top and bottom surfaces;
      at least two microelectronic elements electrically connected to the substrate contacts;
   a microelectronic element capacitor carrier overlying and bonded to the package substrate, the capacitor carrier including:
      a plurality of ground contacts electrically connected to a ground source;
      a plurality of power contacts electrically connected to a power source; and
      capacitor routing lines, wherein at least some of the capacitor routing lines are connected to the plurality of ground contacts and other capacitor routing lines are electrically connected to the plurality of power contacts, wherein the capacitor carrier is positioned laterally adjacent the at least two microelectronic elements and extends at least partially around the at least two microelectronic elements so that an inner edge of the capacitor carrier is adjacent outer edges of the at least two microelectronic elements; and
      a plurality of capacitors joined to the capacitor carrier, each of the plurality of capacitors having a first end joined to one of the plurality of ground contacts and a second end joined to one of the plurality of power contacts, at least some of the plurality of capacitors providing power to at least one of the at least two microelectronic elements.
2. The assembly of example 1, wherein the capacitor carrier is comprised of a low temperature co-fired ceramic.
3. The assembly of example 2, wherein the capacitor carrier further includes a main body, wherein the capacitor routing lines further comprise dedicated power lines and dedicated ground lines extending throughout the main body of the capacitor carrier, and the routing lines of the package substrate further comprises capacitor power lines and capacitor ground lines extending throughout the substrate body.
4. The assembly of example 1, where the capacitor carrier extends contiguously around the at least two microelectronic elements, the capacitor carrier having a peripheral edge spaced away from a peripheral edge of the package substrate, the capacitor carrier being disposed between the peripheral edge of the package substrate and the outer edges of the at least two microelectronic elements.
5. The assembly of example 1, wherein the capacitor carrier comprises a plurality of capacitor carrier components that are positioned around the package substrate to collectively form a shape of a ring, the plurality of capacitor carrier components having an outer peripheral edge spaced away from a peripheral edge of the package substrate.
6. The assembly of example 1, wherein the plurality of capacitors are bonded to a top surface of the capacitor carrier and arranged in arrays across the top surface of the capacitor carrier.
7. The assembly of example 1, wherein the assembly further comprises a heat spreader overlying the plurality of capacitors.
8. The assembly of example 7, wherein the heat spreader further overlies the at least two microelectronic elements.
9. The assembly of example 1, wherein others of the plurality of capacitors are electrically interconnected to a second of the at least two microelectronic elements.
10. The assembly of example 1, wherein the at least two microelectronic elements comprise at least three microelectronic elements, wherein at least one of the at least three microelectronic elements is an integrated circuit chip and two of the at least three microelectronic elements are high-performance computing chips.
11. The assembly of example 1, wherein the capacitor carrier is comprised of a material having a coefficient of thermal expansion ranging from 5 ppm / °C to 10 ppm / °C and a Young's modulus ranging from 150 GPa to 350 GPa.
12. The assembly of example 1, wherein the capacitor carrier is comprised of a material having a coefficient of thermal expansion ranging from 10 ppm/ °C to 15 ppm/ °C and a Young's modulus ranging from 50 GPa to 150 GPa.
13. The assembly of example 1, wherein the package assembly further comprises an interposer that provides an electrical interconnection between the at least two microelectronic elements and the package substrate.
14. A microelectronic element package assembly comprising:
   a package substrate;
   an interposer overlying and bonded to the package substrate;
      at least two microelectronic elements electrically connected to the package substrate through the interposer;
   a capacitor carrier ring ("CCR") overlying the package substrate and extending circumferentially around the at least two microelectronic elements, the CCR comprised of a material having a coefficient of thermal expansion ranging from 5-15 ppm/ °C and a Young's modulus ranging from 25-350 GPa, the CCR further comprising a plurality of ground contacts electrically connected to a ground source and a plurality of power contacts electrically connected to a power source; and
   a plurality of arrays of capacitors, each of the capacitors in the plurality of arrays of capacitors having a first end bonded to one of the plurality of ground contacts and a second end bonded to one of the plurality of power contacts,
   wherein at least some of the plurality of capacitors in one or more of the plurality of arrays of capacitors are electrically connected with one of the at least two microelectronic elements and others of the plurality of capacitors are electrically interconnected with a second of the at least two microelectronic elements through an electrical connection between the CCR and the package substrate.
15. The assembly of example 14, wherein the CCR comprises a laminated ceramic material.
16. The assembly of example 14, wherein the CCR comprises a printed circuit board and the package assembly further comprises another printed circuit board joined to the CCR and overlying the plurality of arrays of capacitors.
17. The assembly of example 14, wherein the capacitors are at least partially embedded within the CCR.
18. The assembly of example 17, further comprising a heat spreader lid overlying the plurality of arrays of capacitors.
19. A chip package assembly comprising:
   a package substrate having at least one power contact electrically connected to a power source;
   at least two chips electrically connected to the package substrate;
   a stiffening element joined to the package substrate and extending at least partially around the at least two chips, the stiffening element electrically connected to a ground source so that the stiffening element is a ground and positioned directly adj acent the at least two chips, and the stiffening element further including at least one pocket, wherein the pocket includes an interior contact surface and interior walls extending around and away from the interior contact surface and terminating in an opening; and
   a plurality of chip capacitors disposed within the at least one pocket, one end of each of the plurality of chip capacitors being joined to the interior contact surface and an other end of each of the plurality of chip capacitors being joined to the power contact.
20. The assembly of example 19, wherein the stiffening element is a monolithic structure.
21. The assembly of example 20, wherein the stiffening element is comprised of a material comprising at least one of the following materials: a polyimide, a FR-4, an aluminum, a stainless steel, and a copper.
22. The assembly of example 21, wherein the stiffening element is further comprised of copper.
23. The assembly of example 19, wherein the stiffening element extends circumferentially around the at least two chips.
24. The assembly of example 19, further comprising an interposer interconnecting the at least two chips to the package substrate.
25. The assembly of example 19, further comprising a heat spreader lid overlying a top surface of the stiffening element.
26. The assembly of example 19, wherein the stiffening element has a height extending along a plane extending perpendicular to a surface of the package substrate to which the stiffening element is attached and that is greater than or equal to a height of the at least two chips in the package.
27. A method of manufacturing a microelectronic element package assembly comprising:
   providing a package substrate having ground and power lines; contact pads disposed at a top surface; and package terminals disposed at a bottom surface;
   electrically connecting at least two microelectronic elements with the contact pads of the package substrate;
   providing a multi-layer ceramic capacitor carrier that includes ground contacts and power contacts each disposed at top and bottom surfaces of the capacitor carrier;
   attaching a plurality of chip capacitors to the capacitor carrier, wherein one end of each of the chip capacitors is bonded to one of the ground contacts and an other end of each of the chip capacitors is bonded to one of the power contacts;
   positioning the capacitor carrier and the attached plurality of chip capacitors laterally adjacent the at least two microelectronic elements so that that the capacitor carrier and the attached chip capacitors extend at least partially around the at least two microelectronic elements; and
   joining the multi-layer ceramic capacitor carrier to the package substrate, wherein at least some of the ground contacts are electrically connected to a ground source and other of the contact pads are power contacts electrically connected to a power source, and at least some of the plurality of capacitors supply power to least one of the at least two microelectronic elements.
28. The method of example 27, further comprising bonding the capacitor carrier to the contact pads of the package substrate.
29. The method of example 27, further comprising providing a heat sink lid that overlies the plurality of capacitors and is attached to the capacitor carrier.
30. The method of example 27, wherein the joining a plurality of chip capacitors to the capacitor carrier further comprises bonding the plurality of chip capacitors to the capacitor carrier, and wherein the joining the capacitor carrier to the package substrate comprises bonding the capacitor carrier to the package substrate, wherein the bonding the plurality of chip capacitors occurs before joining the capacitor carrier to the substrate.
31. A method of manufacturing a microelectronic element package assembly comprising:
   providing a package substrate having ground routing lines and power routing lines, contact pads disposed at a top surface of the substrate, and package terminals disposed at a bottom surface of the package substrate;
   electrically connecting at least two microelectronic elements with the package substrate;
   positioning a multi-layer ceramic capacitor carrier laterally adjacent the at least two microelectronic elements so that that the capacitor carrier extends at least partially around the at least two microelectronic elements, the capacitor carrier further including contact pads disposed at top and bottom surfaces of the capacitor carrier, at least some of the contact pads being ground contacts electrically connected to a ground source and other of the contact pads being power contacts connected to a power source;
   joining the capacitor carrier to the package substrate; and
   joining a plurality of microelectronic element capacitors to the capacitor carrier, wherein one end of each of the capacitors is bonded to one of the ground contacts and the other end of each of the capacitors is bonded to one of the power contacts, at least some of the plurality of capacitors supplying power to least one of the at least two microelectronic elements.
32. The method of example 31, further comprising bonding the capacitor carrier to the contact pads of the package substrate.
33. The method of example 31, further comprising providing a heat sink lid that overlies the plurality of capacitors.
34. The method of example 31, further comprising arranging the plurality of capacitors in arrays across the top surface of the capacitor carrier.
35. A microelectronic element package assembly comprising:
   a package substrate having a substrate body, substrate contacts disposed at a top surface of the substrate body, package terminals disposed at a bottom surface of the substrate body, and routing lines disposed between the top and bottom surfaces;
      at least two microelectronic elements electrically connected to the substrate contacts;
   a microelectronic element capacitor carrier overlying and bonded to the package substrate, the capacitor carrier including:
      a plurality of ground contacts electrically connected to a ground source;
      power contacts electrically connected to a power source, at least some of the power contacts disposed at a top surface of the capacitor carrier and other power contacts disposed at a bottom surface of the capacitor carrier; and
      a plurality of vias extending between top and bottom surfaces of the capacitor carrier and electrically connecting the at least some of the power contacts disposed at the top and bottom surfaces of the capacitor carrier;
      wherein the capacitor carrier is positioned laterally adjacent the at least two microelectronic elements and extends at least partially around the at least two microelectronic elements so that an inner edge of the capacitor carrier is adjacent outer edges of the at least two microelectronic elements; and
      a plurality of capacitors joined to the capacitor carrier, each of the plurality of capacitors having a first end joined to one of the ground contacts and a second end joined to one of the power contacts, at least some of the plurality of capacitors providing power to at least one of the at least two microelectronic elements,
      wherein a body of the capacitor carrier is the ground source.

## Claims

1. A microelectronic element package assembly comprising:
a package substrate having a substrate body, substrate contacts disposed at a top surface of the substrate body, package terminals disposed at a bottom surface of the substrate body, and routing lines disposed between the top and bottom surfaces;
at least two microelectronic elements electrically connected to the substrate contacts;
a microelectronic element capacitor carrier overlying and bonded to the package substrate, the capacitor carrier including:
a plurality of ground contacts electrically connected to a ground source;
a plurality of power contacts electrically connected to a power source; and
capacitor routing lines, wherein at least some of the capacitor routing lines are connected to the plurality of ground contacts and other capacitor routing lines are electrically connected to the plurality of power contacts, wherein the capacitor carrier is positioned laterally adjacent the at least two microelectronic elements and extends at least partially around the at least two microelectronic elements so that an inner edge of the capacitor carrier is adjacent outer edges of the at least two microelectronic elements; and
a plurality of capacitors j oined to the capacitor carrier, each of the plurality of capacitors having a first end joined to one of the plurality of ground contacts and a second end joined to one of the plurality of power contacts, at least some of the plurality of capacitors providing power to at least one of the at least two microelectronic elements.

2. The assembly of claim 1, wherein the capacitor carrier is comprised of a low temperature co-fired ceramic.

3. The assembly of claim 2, wherein the capacitor carrier further includes a main body, wherein the capacitor routing lines further comprise dedicated power lines and dedicated ground lines extending throughout the main body of the capacitor carrier, and the routing lines of the package substrate further comprises capacitor power lines and capacitor ground lines extending throughout the substrate body.

4. The assembly of any one of claims 1-3, where the capacitor carrier extends contiguously around the at least two microelectronic elements, the capacitor carrier having a peripheral edge spaced away from a peripheral edge of the package substrate, the capacitor carrier being disposed between the peripheral edge of the package substrate and the outer edges of the at least two microelectronic elements.

5. The assembly of any one of claims 1-4, wherein the capacitor carrier comprises a plurality of capacitor carrier components that are positioned around the package substrate to collectively form a shape of a ring, the plurality of capacitor carrier components having an outer peripheral edge spaced away from a peripheral edge of the package substrate.

6. The assembly of any one of claims 1-5, wherein the plurality of capacitors are bonded to a top surface of the capacitor carrier and arranged in arrays across the top surface of the capacitor carrier.

7. The assembly of any one of claims 1-6, wherein the assembly further comprises a heat spreader overlying the plurality of capacitors; and/or
wherein the heat spreader further overlies the at least two microelectronic elements.

8. The assembly of any one of claims 1-7, wherein others of the plurality of capacitors are electrically interconnected to a second of the at least two microelectronic elements.

9. The assembly of any one of claims 1-8, wherein the at least two microelectronic elements comprise at least three microelectronic elements, wherein at least one of the at least three microelectronic elements is an integrated circuit chip and two of the at least three microelectronic elements are high-performance computing chips.

10. The assembly of any one of claims 1-9, wherein the capacitor carrier is comprised of a material having a coefficient of thermal expansion ranging from 5 ppm / °C to 10 ppm / °C and a Young's modulus ranging from 150 GPa to 350 GPa; and/or

11. The assembly of any one of claims 1-9, wherein the capacitor carrier is comprised of a material having a coefficient of thermal expansion ranging from 10 ppm/ °C to 15 ppm/ °C and a Young's modulus ranging from 50 GPa to 150 GPa.

12. The assembly of any one of claims 1-11, wherein the package assembly further comprises an interposer that provides an electrical interconnection between the at least two microelectronic elements and the package substrate.

13. A method of manufacturing a microelectronic element package assembly comprising:
providing a package substrate having ground routing lines and power routing lines, contact pads disposed at a top surface of the substrate, and package terminals disposed at a bottom surface of the package substrate;
electrically connecting at least two microelectronic elements with the package substrate;
positioning a multi-layer ceramic capacitor carrier laterally adjacent the at least two microelectronic elements so that that the capacitor carrier extends at least partially around the at least two microelectronic elements, the capacitor carrier further including contact pads disposed at top and bottom surfaces of the capacitor carrier, at least some of the contact pads being ground contacts electrically connected to a ground source and other of the contact pads being power contacts connected to a power source;
joining the capacitor carrier to the package substrate; and
joining a plurality of microelectronic element capacitors to the capacitor carrier, wherein one end of each of the capacitors is bonded to one of the ground contacts and the other end of each of the capacitors is bonded to one of the power contacts, at least some of the plurality of capacitors supplying power to least one of the at least two microelectronic elements.

14. The method of claim 13, further comprising bonding the capacitor carrier to the contact pads of the package substrate.

15. The method of any one of claims 13 or 14, further comprising:
providing a heat sink lid that overlies the plurality of capacitors; and/or
arranging the plurality of capacitors in arrays across the top surface of the capacitor carrier.
